# EUROPEAN PATENT APPLICATION

(11) **EP 4 580 330 A1**
(43) Date of publication of application: **02.07.2025**
(21) Application number: 24203694.5
(22) Date of filing: 30.09.2024
(51) Int. Cl.: H10B 43/10, H10B 43/40, H10B 43/27, H10B 43/50

(54) **SEMICONDUCTOR DEVICE AND ELECTRONIC SYSTEM INCLUDING THE SAME**

(30) Priority: 29.12.2023 KR 20230196247
(71) Applicant: Samsung Electronics Co., Ltd, Suwon-si, Gyeonggi-do 16677 (KR)
(72) Inventor: KIM, Kang Lib, 16677 Suwon-si (KR)
(74) Representative: Marks & Clerk LLP

(57) **Abstract**

A semiconductor device includes a substrate including a cell array region and a connection region, a plurality of ground selection gate patterns spaced apart from each other, a plurality of cell gate patterns vertically stacked on the plurality of ground selection gate patterns, separation structures vertically extending into the cell gate patterns and disposed between the plurality of ground selection gate patterns and spaced apart from each other in a first direction in the connection region, and first dummy vertical structures disposed between the separation structures that are adjacent in the first direction and between a first ground selection gate pattern and a second ground selection gate pattern adjacent to the first ground selection gate pattern. Each of the first dummy vertical structures includes a vertical portion that vertically extends into the cell gate patterns and an extension that protrudes horizontally from the vertical portion.

## Description

### BACKGROUND

The present disclosure relates to relates to a semiconductor device and an electronic system including the same.

Semiconductor devices capable of storing high-capacity data may be desired to meet data storage needs of electronic systems. Accordingly, techniques that may increase the data storage capacity of the semiconductor device are being researched. For example, as one of the methods for increasing the data storage capacity of the semiconductor device, a semiconductor device that includes three-dimensionally arranged memory cells instead of two-dimensionally arranged memory cells has been proposed.

### SUMMARY

Some example embodiments provide a semiconductor device with improved reliability and integration.

Some example embodiments provide an electronic system including a semiconductor device.

Example embodiments are not limited to addressing the problems mentioned above and embodiments may address other problems not mentioned. Example embodiments will be described below, and variations of the example embodiments will be clearly understood by those skilled in the art from the description below.

According to some example embodiments, a semiconductor device may include a substrate including a cell array region and a connection region, a plurality of ground selection gate patterns with each ground selection gate pattern spaced apart from each other and disposed at the same level as each other relative to a top surface of the substrate, a plurality of cell gate patterns vertically stacked on the plurality of ground selection gate patterns, a plurality of separation structures, with each separation structure vertically extending into the cell gate patterns and disposed between respective ground selection gate patterns of the plurality of ground selection gate patterns and spaced apart from each other in a first direction in the connection region, and a plurality of dummy vertical structures disposed between a first separation structure and a second separation structure that are adjacent in the first direction and between a first ground selection gate and a ground selection pattern, wherein each of the dummy vertical structures includes a vertical portion that extends vertically into the cell gate patterns and an extension that protrudes horizontally from the vertical portion at the same level as the ground selection gate patterns, and the extension of each of the dummy vertical structures are connected to each other and are in contact with the first separation and the second separation structure.

According to some example embodiments, a semiconductor device may include a substrate including a cell array region and a connection region, first separation structures extending in a first direction parallel to a top surface of the substrate, a stacked structure disposed between first separation structures that are adjacent in a second direction perpendicular to the first direction and including gate patterns and interlayer insulating layers alternately stacked vertically on the substrate, the gate patterns including a plurality of ground selection gate patterns with each ground selection gate pattern spaced apart from each other at the same level from the top surface of the substrate, and a plurality of cell gate patterns vertically stacked on the plurality of ground selection gate patterns, second separation structures extending into the plurality of cell gate patterns that are adjacent in the second direction and disposed between the ground selection gate patterns, and spaced apart from each other in the connection region in the first direction, first dummy vertical structures disposed between second separation structures adjacent to each other in the first direction and between the ground selection gate patterns that are adjacent in the second direction, and second dummy vertical structures extending into the stacked structure in the connection region, wherein each of the first and second dummy vertical structures includes a vertical portion that extends vertically into the cell gate patterns and an extension that protrudes horizontally from the vertical portion at the same level as the ground selection gate patterns, and each extension of the first dummy vertical structures are connected to each other and are in contact with the second separation structures that are adjacent to each other in the first direction.

According to some example embodiments, an electrical system may include a semiconductor device including a substrate including a cell array region and a connection region, a plurality of ground selection gate patterns with each ground selection gate pattern spaced apart from each other and disposed at the same level from a top surface of the substrate, a plurality of cell gate patterns vertically stacked on the plurality of ground selection gate patterns, separation structures vertically extending into the cell gate patterns and disposed between adjacent ground selection patterns of the plurality of ground selection gate patterns, and spaced apart from each other in the connection region in a first direction, and dummy vertical structures between adjacent separation structures and between the adjacent ground selection gate patterns, and an input/output pad electrically connected to peripheral circuits, and a controller electrically connected to the semiconductor device through the input/output pad and controlling the semiconductor device, wherein each of the dummy vertical structures includes a vertical portion that vertically extends into the cell gate patterns and an extension that protrudes horizontally from the vertical portion at the same level as the ground selection gate patterns, and the extension of each of the dummy vertical structures are connected to each other and are in contact with the separation structures adj acent to each other in the first direction.

At least some of the above and other features of the invention are set out in the claims.

Specific details of other embodiments are included in the detailed description and drawings.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1 is a diagram schematically showing an electronic system including a semiconductor device according to some example embodiments of the present disclosure.
FIG. 2 is a perspective view schematically showing an electronic system including a semiconductor device according to some example embodiments of the present disclosure.
FIGS. 3 and 4 are cross-sectional views schematically showing semiconductor packages according to some example embodiments of the present disclosure.
FIG. 5 is a plan view of a semiconductor device according to some example embodiments of the present disclosure.
FIGS. 6A, 6B, 6C, and 6D are cross-sectional views of semiconductor devices according to various some example embodiments of the present disclosure, taken along lines A-A', B-B', C-C', and D-D' of FIG. 5.
FIG. 7A is a plan view showing ground selection gate patterns provided in a stacked structure according to some example embodiments of the present disclosure.
FIG. 7B is a plan view showing cell gate patterns provided in a stacked structure according to some example embodiments of the present disclosure.
FIGS. 8A, 8B, 8C, 8D, and 8E are cross-sectional views of semiconductor devices according to various some example embodiments of the present disclosure, taken along line A-A' ofFIG. 5.
FIG. 9A is a plan view of a semiconductor device according to some example embodiments of the present disclosure.
FIG. 9B is a plan view showing one cell gate pattern provided in a stacked structure according to some example embodiments of the present disclosure.
FIG. 9C is a plan view showing ground selection gate patterns provided in a stacked structure according to some example embodiments of the present disclosure.
FIG. 9D is a cross-sectional view of a semiconductor device according to various some example embodiments of the present disclosure, taken along line D-D' of FIG. 9A.
FIGS. 10A and 10B are plan views of semiconductor devices according to various some example embodiments of the present disclosure.
FIG. 11 is a cross-sectional view of a semiconductor device according to some example embodiments of the present disclosure.
FIGS. 12A, 13A, 14A, 15A, 16A, 17A, and 18A are diagrams illustrating a method of manufacturing a semiconductor device according to some example embodiments of the present disclosure, and show cross-sections taken along line A-A' of FIG. 5A.
FIGS. 12B, 13B, 14B, 15B, 16B, 17B, and 18B are diagrams illustrating a method of manufacturing a semiconductor device according to some example embodiments of the present disclosure, and show cross-sections taken along line B-B' of FIG. 5A.
FIGS. 12C, 13C, 14C, 15C, 16C, 17C, and 18C are diagrams illustrating a method of manufacturing a semiconductor device according to some example embodiments of the present disclosure, and show cross-sections taken along line C-C' of FIG. 5A.

### DETAILED DESCRIPTION

Hereinafter, with reference to the drawings, a semiconductor device and an electronic system including the same according to some example embodiments of the present disclosure will be described in detail.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

As used herein, components described as being "electrically connected" are configured such that an electrical signal can be transferred from one component to the other (although such electrical signal may be attenuated in strength as it is transferred and may be selectively transferred). Moreover, components that are "directly electrically connected" share a common electrical node through electrical connections by one or more conductors, such as, for example, wires, pads, internal electrical lines, through vias, etc. As such, directly electrically connected components do not include components electrically connected through active elements, such as transistors or diodes.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

Terms such as "same," "equal," "planar," or "coplanar," as used herein when referring to orientation, layout, location, shapes, sizes, compositions, amounts, or other measures do not necessarily mean an exactly identical orientation, layout, location, shape, size, composition, amount, or other measure, but are intended to encompass nearly identical orientation, layout, location, shapes, sizes, compositions, amounts, or other measures within acceptable variations that may occur, for example, due to manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

It will be appreciated that "planarization," "co-planar," "planar," etc., as used herein refer to structures (e.g., surfaces) that need not be perfectly geometrically planar, but may include acceptable variances that may result from standard manufacturing processes.

Throughout the specification, when a component is described as "including" a particular element or group of elements, it is to be understood that the component is formed of only the element or the group of elements, or the element or group of elements may be combined with additional elements to form the component, unless the context clearly and/or explicitly describes the contrary. The term "consisting of," on the other hand, indicates that a component is formed only of the element(s) listed.

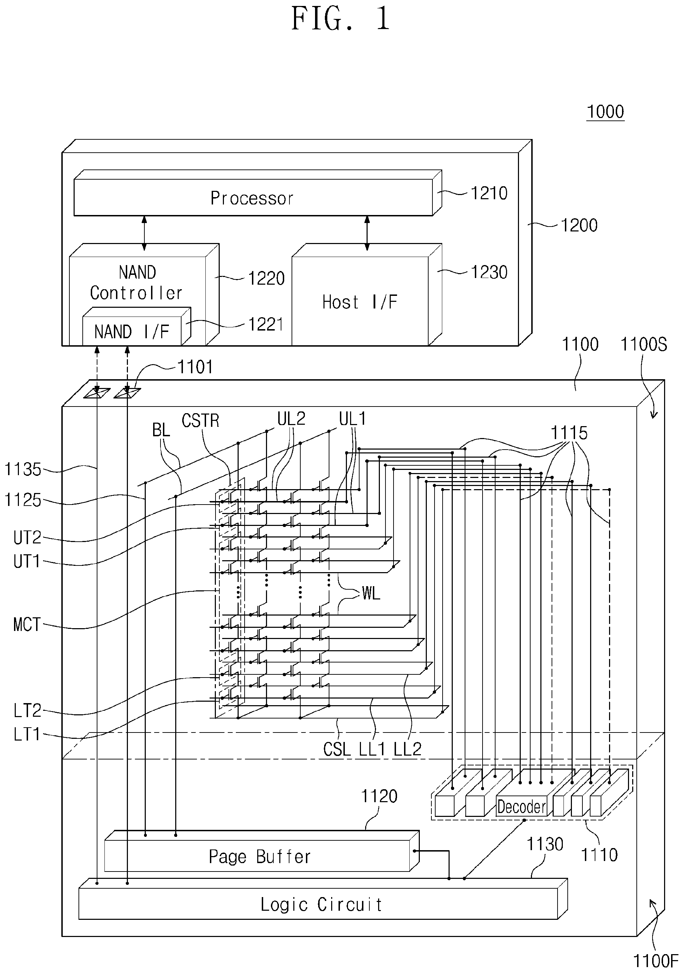

FIG. 1 is a diagram schematically showing an electronic system including a semiconductor device according to some example embodiments of the present disclosure.

Referring to FIG. 1, an electronic system 1000 according to some example embodiments may include a semiconductor device 1100 and a controller 1200 electrically connected to the semiconductor device 1100. The electronic system 1000 may be a storage device including one or more semiconductor devices 1100 or an electronic device including the storage device. For example, the electronic system 1000 may be a solid state drive (SSD) device, a universal serial bus (USB), a computing system, a medical system, or a communication system, in which at least one semiconductor device 1100 is provided.

The semiconductor device 1100 may be a nonvolatile memory device (e.g., a NAND FLASH memory device). The semiconductor device 1100 may include a first structure 1100F and a second structure 1100S on the first structure 1100F. In some embodiments, the first structure 1100F may be disposed beside the second structure 11005.

The first structure 1100F may be a peripheral circuit structure including a decoder circuit 1110, a page buffer circuit 1120, and a logic circuit 1130. The second structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may be variously changed, according to embodiments.

In embodiments, the upper transistors UT1 and UT2 may include at least one string selection transistor, and the lower transistors LT1 and LT2 may include at least one ground selection transistor. The gate lower lines LL1 and LL2 may be respectively used as gate electrodes of the lower transistors LT1 and LT2. The word lines WL may be respectively used as gate electrodes of the memory cell transistors MCT, and the gate upper lines UL1 and UL2 may be respectively used as gate electrodes of the upper transistors UT1 and UT2.

The memory cells MCT of each memory cell string CSTR may be controlled by a back gate line.

The common source line CSL, the first and second gate lower lines LL1 and LL2, the word lines WL, and the first and second gate upper lines UL1 and UL2 may be electrically connected to the decoder circuit 1110 through first connection lines 1115, which are extended from the first structure 1100F into the second structure 1100S. The bit lines BL may be electrically connected to the page buffer circuit 1120 through second connection lines 1125, which are extended from the first structure 1100F to the second structure 1100S.

In the first structure 1100F, the decoder circuit 1110 and the page buffer circuit 1120 may be configured to perform a control operation on at least selected one of the memory cell transistors MCT. The decoder circuit 1110 and the page buffer circuit 1120 may be controlled by the logic circuit 1130. The semiconductor device 1100 may communicate with the controller 1200 through an input/output pad 1101, which is electrically connected to the logic circuit 1130. The input/output pad 1101 may be electrically connected to the logic circuit 1130 through an input/output connection line 1135, which is extended from the first structure 1100F to the second structure 11005.

Although not shown in FIG. 1, the first structure 1100F may include a voltage generator (not shown). The voltage generator may generate program voltage, read voltage, pass voltage, and verification voltage required for the operation of the memory cell strings CSTR. Here, the program voltage may be a relatively high voltage (e.g., 20V to 40V) compared to the read voltage, pass voltage, and verification voltage.

In embodiments, the first structure 1100F may include high voltage transistors and low voltage transistors. The decoder circuit 1110 may include pass transistors connected to the word lines WL of the memory cell strings CSTR. The pass transistors may include high voltage transistors that may withstand high voltages such as the program voltage applied to the word lines WL during a program operation. The page buffer circuit 1120 may also include high voltage transistors that may withstand high voltage.

The controller 1200 may include a processor 1210, a NAND controller 1220, and a host interface 1230. In embodiments, the electronic system 1000 may include a plurality of semiconductor devices 1100, and in this case, the controller 1200 may control the semiconductor devices 1100.

The processor 1210 may control overall operations of the electronic system 1000 including the controller 1200. The processor 1210 may be operated based on a specific firmware and may control the NAND controller 1220 to access the semiconductor device 1100. The NAND controller 1220 may include a NAND interface 1221, which is used to communicate with the semiconductor device 1100. The NAND interface 1221 may be configured to transmit and receive control commands, which are used to control the semiconductor device 1100, data, which are written in or read from the memory cell transistors MCT of the semiconductor device 1100, and so forth. The host interface 1230 may be configured to allow for communication between the electronic system 1000 and an external host. When the processor 1210 receives a control command transmitted from the external host through the host interface 1230, the processor 1210 may control the semiconductor device 1100 in response to the control command.

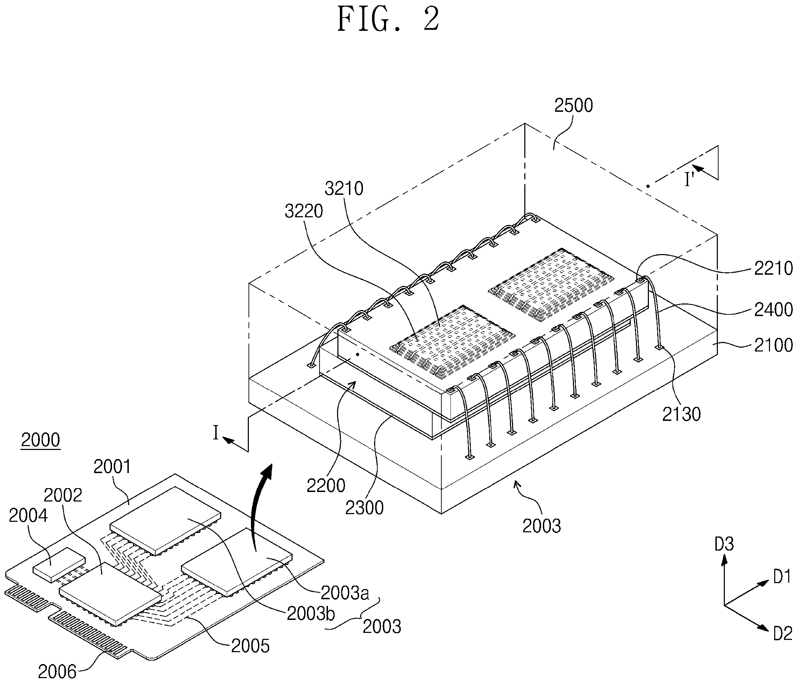

FIG. 2 is a perspective view schematically showing an electronic system including a semiconductor device according to some example embodiments of the present disclosure.

Referring to FIG. 2, an electronic system 2000 according to some example embodiments may include a main substrate 2001 and a controller 2002, at least one semiconductor package 2003, and a DRAM 2004, which are mounted on the main substrate 2001. The semiconductor package 2003 and the DRAM 2004 may be connected to the controller 2002 by interconnection patterns 2005, which are formed in the main substrate 2001.

The main substrate 2001 may include a connector 2006, which includes a plurality of pins coupled to an external host. In the connector 2006, the number and arrangement of the pins may be changed depending on a communication interface between the electronic system 2000 and the external host. In embodiments, the electronic system 2000 may communicate with the external host, in accordance with an interface standard, such as universal serial bus (USB), peripheral component interconnect express (PCI-Express), serial advanced technology attachment (SATA), universal flash storage (UFS) M-Phy, or the like. In embodiments, the electronic system 2000 may be driven by electrical power, which is supplied from the external host through the connector 2006. The electronic system 2000 may further include a power management integrated circuit (PMIC) that is configured to distribute electrical power, which is supplied from the external host, to the controller 2002 and the semiconductor package 2003.

The controller 2002 may be configured to control a writing or reading operation for the semiconductor package 2003 and to improve an operation speed of the electronic system 2000.

The DRAM 2004 may be a buffer memory, which relieves technical difficulties caused by a difference in speed between the semiconductor package 2003, which serves as a data storage device, and an external host. The DRAM 2004 in the electronic system 2000 may serve as a cache memory and may be used as a storage space, which is configured to store data temporarily during a control operation for the semiconductor package 2003. When the electronic system 2000 includes the DRAM 2004, the controller 2002 may further include a DRAM controller for controlling the DRAM 2004, in addition to a NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200 on the package substrate 2100, adhesive layers 2300 disposed on respective bottom surfaces of the semiconductor chips 2200, a connection structure 2400 electrically connecting the semiconductor chips 2200 to the package substrate 2100, and a molding layer 2500 disposed on the package substrate 2100 to cover the semiconductor chips 2200 and the connection structure 2400.

The package substrate 2100 may be a printed circuit board including upper pads 2130. Each of the semiconductor chips 2200 may include an input/output pad 2210. The input/output pad 2210 may correspond to the input/output pad 1101 of FIG. 1. Each of the semiconductor chips 2200 may include stacked structures 3210 and vertical structures 3220. Each of the semiconductor chips 2200 may include a semiconductor device, which will be described below, according to some example embodiments.

In embodiments, the connection structure 2400 may be a bonding wire, which is provided to electrically connect the input/output pad 2210 to the upper pads 2130. Thus, in each of the first and second semiconductor packages 2003a and 2003b, the semiconductor chips 2200 may be electrically connected to each other in a bonding wire manner and may be electrically connected to the upper pads 2130 of the package substrate 2100. In some embodiments, in each of the first and second semiconductor packages 2003a and 2003b, the semiconductor chips 2200 may be electrically connected to each other by a connection structure including through-silicon vias (TSV) instead of or in addition to, the connection structure 2400 provided in the form of bonding wires.

In embodiments, the controller 2002 and the semiconductor chips 2200 may be included in a single package. In some embodiments, the controller 2002 and the semiconductor chips 2200 may be mounted on an additional interposer substrate different from the main substrate 2001 and may be connected to each other through interconnection lines, which are provided in the interposer substrate.

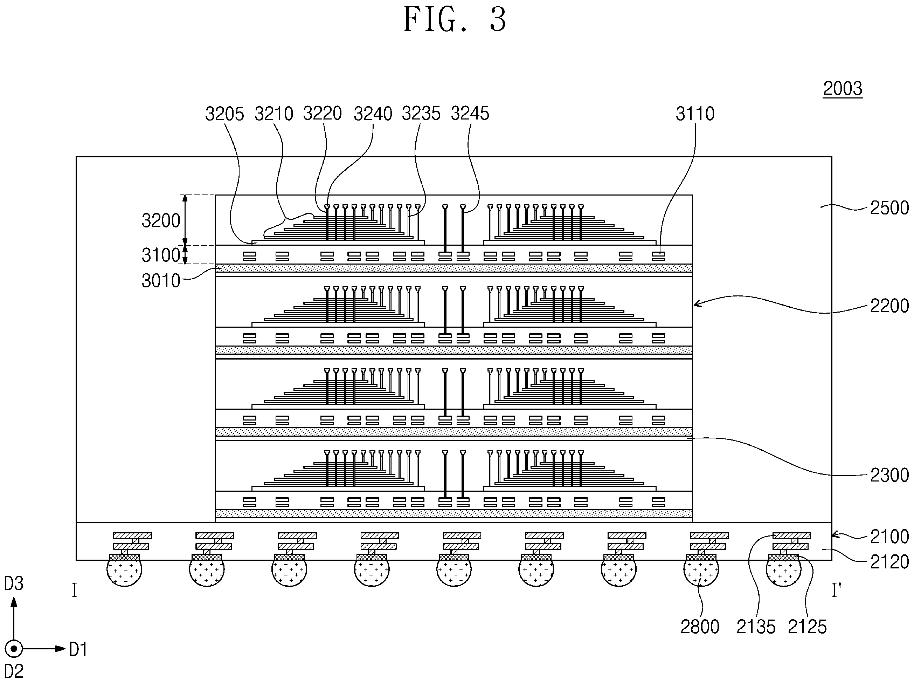

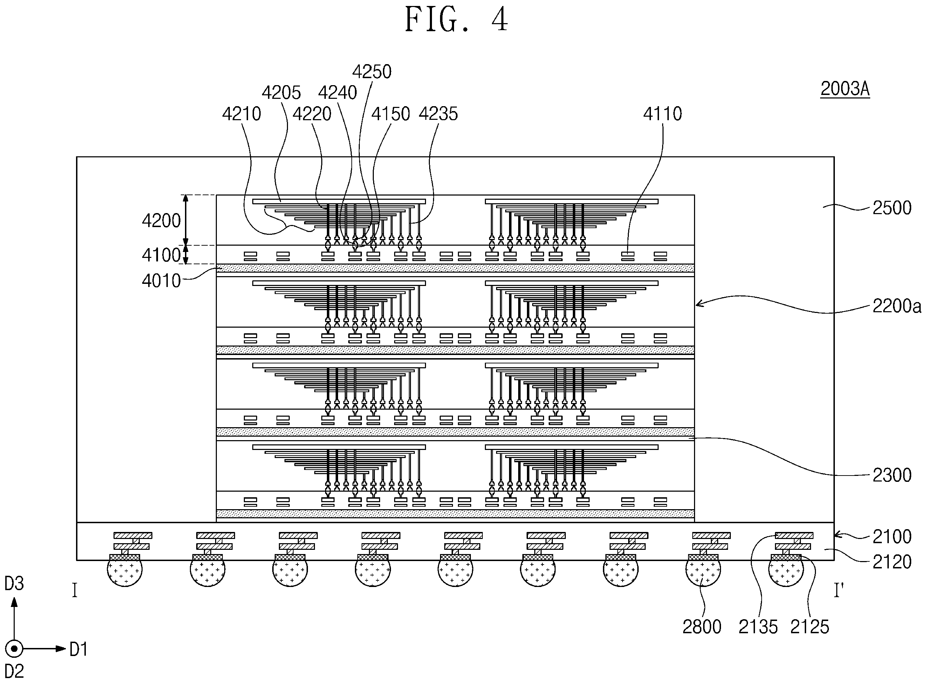

FIGS. 3 and 4 are cross-sectional views schematically showing semiconductor packages according to some example embodiments of the present disclosure. FIGS. 3 and 4 are sectional views, which are taken along a line I-I' of FIG. 2, and illustrate two different examples of the semiconductor package of FIG. 2.

Referring to FIG. 3, the package substrate 2100 of the semiconductor package 2003 may be a printed circuit board. The package substrate 2100 may include a package substrate body portion 2120, the upper pads 2130 (e.g., see FIG. 1), which are disposed on a top surface of the package substrate body portion 2120, lower pads 2125, which are disposed on or exposed through a lower surface of the package substrate body portion 2120, and internal lines 2135, which are disposed in the package substrate body portion 2120 to electrically connect the upper pads 2130 to the lower pads 2125. The upper pads 2130 may be electrically connected to the connection structures 2400. The lower pads 2125 may be connected to the interconnection patterns 2005 of the main substrate 2001 of the electronic system 2000 shown in FIG. 2 through conductive connection portions 2800.

Each of the semiconductor chips 2200 may include a semiconductor substrate 3010 and a first structure 3100 and a second structure 3200, which are sequentially stacked on the semiconductor substrate 3010. The first structure 3100 may include a peripheral circuit region including peripheral lines 3110. The second structure 3200 may include a source structure 3205, a stacked structure 3210 on the source structure 3205, vertical structures 3220 and separation structures (not visible) penetrating the stacked structure 3210, bit lines 3240 electrically connected to the vertical structures 3220, and cell contact plugs 3235 electrically connected to the word lines WL (e.g., see FIG. 1) of the stacked structure 3210. Each of the first and second structures 3100 and 3200 and the semiconductor chips 2200 may further include separation structures to be described below.

Each of the semiconductor chips 2200 may include a penetration line 3245, which is electrically connected to the peripheral lines 3110 of the first structure 3100 and is extended into the second structure 3200. The penetration line 3245 may be disposed outside the stacked structure 3210, and the penetration line 3245 may be provided to further penetrate the stacked structure 3210. Each of the semiconductor chips 2200 may further include the input/output pad 2210 (e.g., see FIG. 2), which is electrically connected to the peripheral lines 3110 of the first structure 3100.

Referring to FIG. 4, in the semiconductor package 2003A, each of the semiconductor chips 2200 a may include a semiconductor substrate 4010, a first structure 4100 on the semiconductor substrate 4010, and a second structure 4200, which is provided on the first structure 4100 and is bonded to the first structure 4100 in a wafer bonding manner.

The first structure 4100 may include a peripheral circuit region including a peripheral line 4110 and first bonding structures 4150. The second structure 4200 may include a source structure 4205, a stacked structure 4210 between the source structure 4205 and the first structure 4100, vertical structures 4220 and a separation structure (not visible) penetrating through the stacked structure 4210, and second bonding structures 4250, which are electrically and respectively connected to the vertical structures 4220 and the word lines WL (e.g., see FIG. 1) of the stacked structure 4210. For example, the second bonding structures 4250 may be electrically connected to the vertical structures 4220 and the word lines WL (e.g., see FIG. 1), respectively, through bit lines 4240 electrically connected to the vertical structures 4220 and cell contact plugs 4235 electrically connected to the word lines WL (e.g., see FIG. 1). The first bonding structures 4150 of the first structure 4100 may be in contact with and bonded to the second bonding structures 4250 of the second structure 4200. The bonded portions of the first bonding structures 4150 and the second bonding structures 4250 may be formed of and/or include, for example, copper (Cu).

Each of the first and second structures 4100 and 4200 and the semiconductor chips 2200a may further include a source structure according to embodiments to be described below. Each of the semiconductor chips 2200 a may further include the input/output pad 2210 (e.g., see FIG. 2), which is electrically connected to the peripheral lines 4110 of the first structure 4100.

The semiconductor chips 2200 of FIG. 3 and the semiconductor chips 2200a of FIG. 4 may be electrically connected to each other by the connection structures 2400, which are provided in the form of bonding wires. However, in embodiments, semiconductor chips provided in each semiconductor package (e.g., the semiconductor chips 2200 of FIG. 3 and the semiconductor chips 2200a of FIG. 4) may be electrically connected to each other through a connection structure including through-silicon vias (TSV).

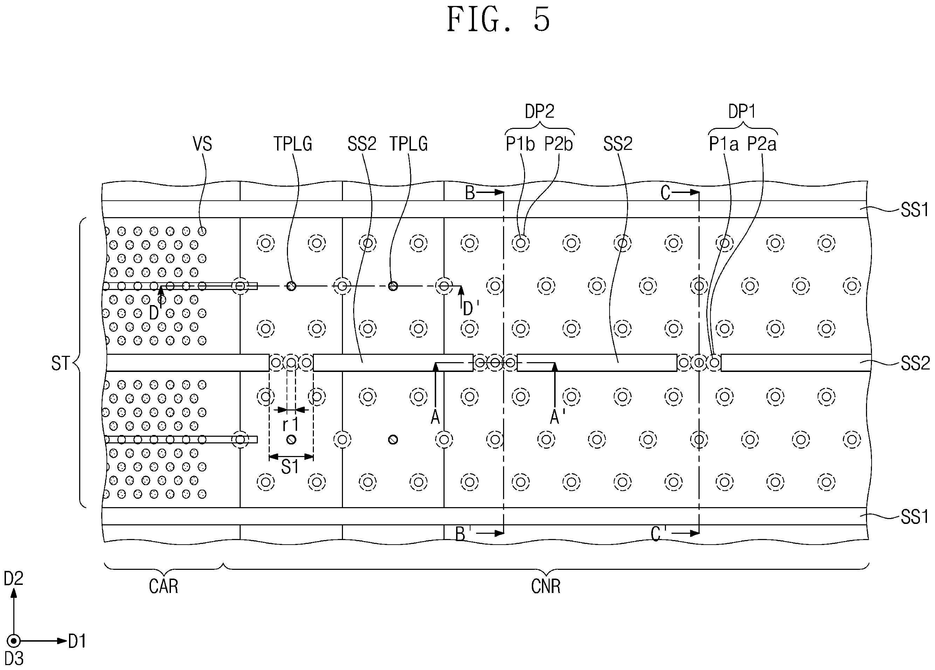

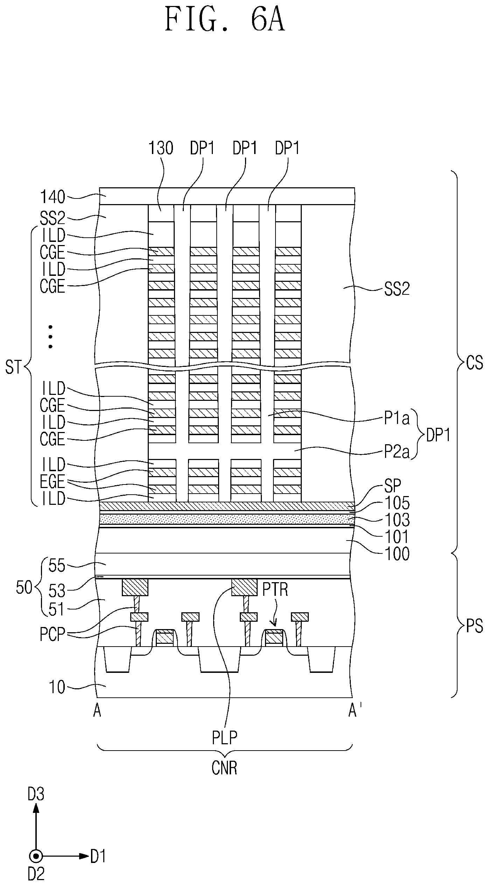

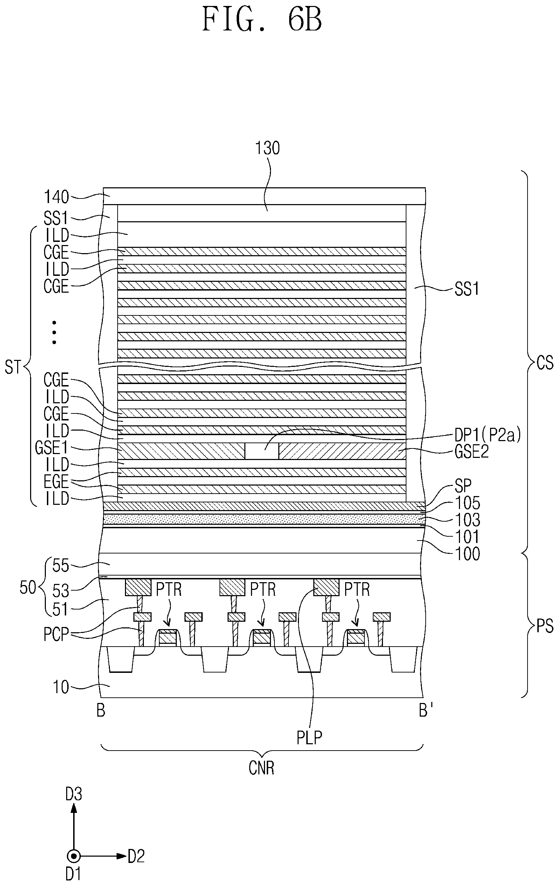

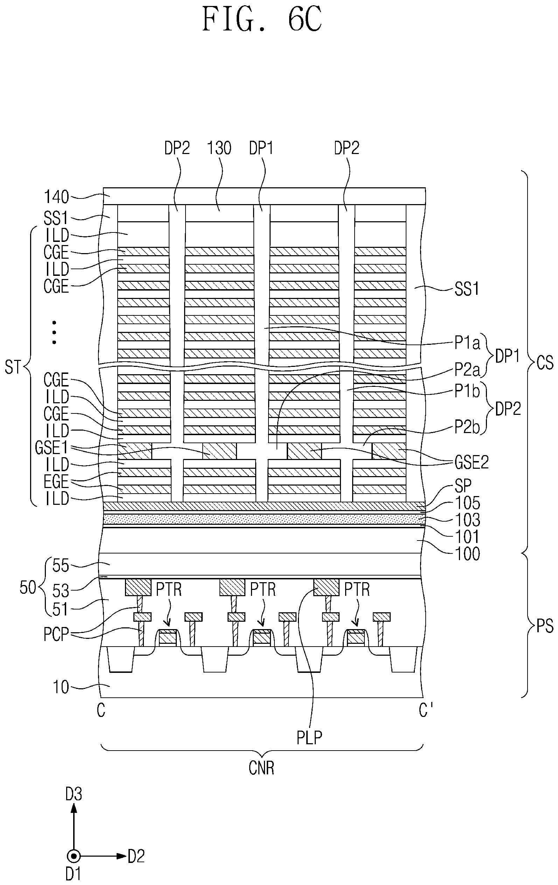

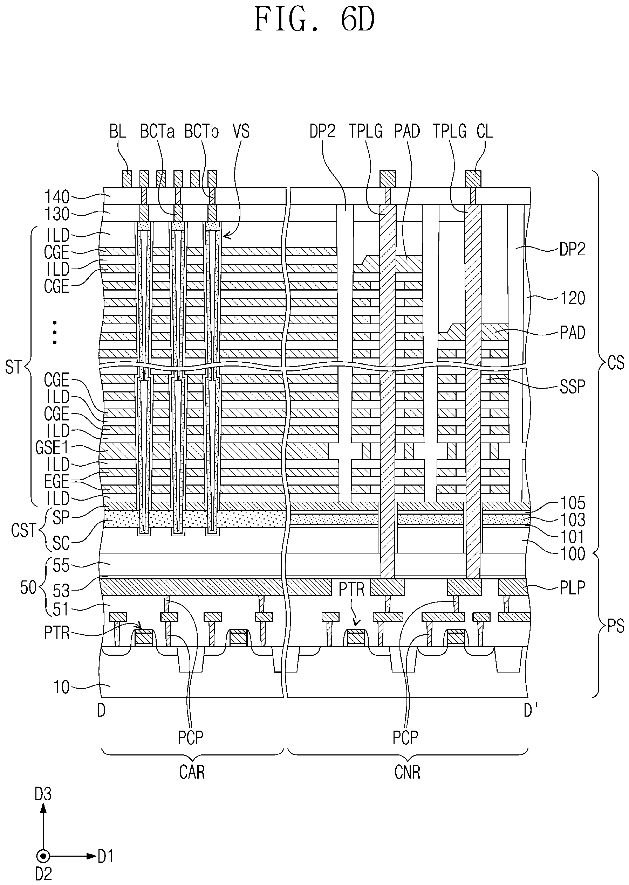

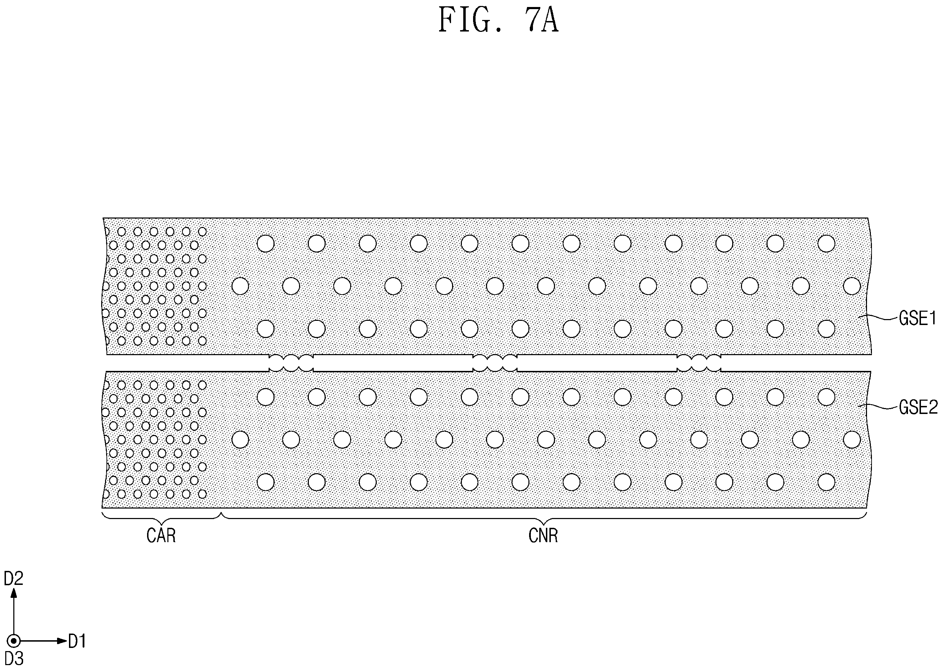

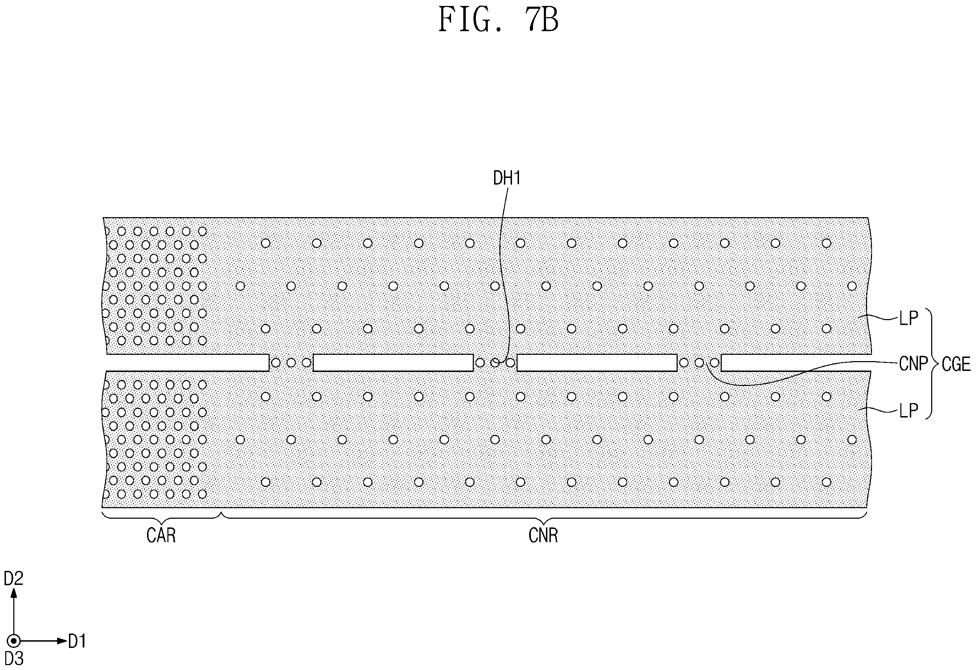

FIG. 5 is a plan view of a semiconductor device according to some example embodiments of the present disclosure. FIGS. 6A, 6B, 6C, and 6D are cross-sectional views of semiconductor devices according to various some example embodiments of the present disclosure, taken along lines A-A', B-B', C-C', and D-D' of FIG. 5. FIG. 7A is a plan view showing ground selection gate patterns provided in a stacked structure according to some example embodiments of the present disclosure. FIG. 7B is a plan view showing cell gate patterns provided in a stacked structure according to some example embodiments of the present disclosure.

Referring to FIGS. 5, 6A, 6B, 6C, and 6D, semiconductor devices according to some example embodiments of the present disclosure may include a peripheral circuit structure PS and a cell array structure CS on the peripheral circuit structure PS.

The peripheral circuit structure PS may include peripheral circuits PTR integrated on a front surface of a semiconductor substrate 10 and a lower insulating layer 50 covering the peripheral circuits PTR. The semiconductor substrate 10 may be a silicon substrate. The semiconductor substrate 10 may include a cell array region CAR and a connection region CNR.

Peripheral circuits PTR may be row and column decoders, page buffers, and control circuits. In detail, the peripheral circuits PTR may include NMOS and PMOS transistors. Peripheral circuit lines may be electrically connected to the peripheral circuits PTR through peripheral contact plugs PCP.

A lower insulating layer 50 may be provided on the entire surface of the semiconductor substrate 10. The lower insulating layer 50 may cover the peripheral circuits PTR, peripheral contact plugs PCP, and peripheral circuit lines PLP on the semiconductor substrate 10. The peripheral contact plugs PCP and peripheral circuit lines PLP may be electrically connected to peripheral circuits PTR.

The lower insulating layer 50 may include insulating layers stacked in multiple layers. For example, the lower insulating layer 50 may include a silicon oxide layer, a silicon nitride layer, a silicon oxynitride layer, and/or a low dielectric layer. As an example, the lower insulating layer 50 may include a first lower insulating layer 51, a second lower insulating layer 55, and an etch stop layer 53 between the first and second lower insulating layers 51 and 55. The etch stop layer 53 may include an insulating material different from the first and second lower insulating layers 51 and 55 and may cover top surfaces of the uppermost peripheral circuit line PLP.

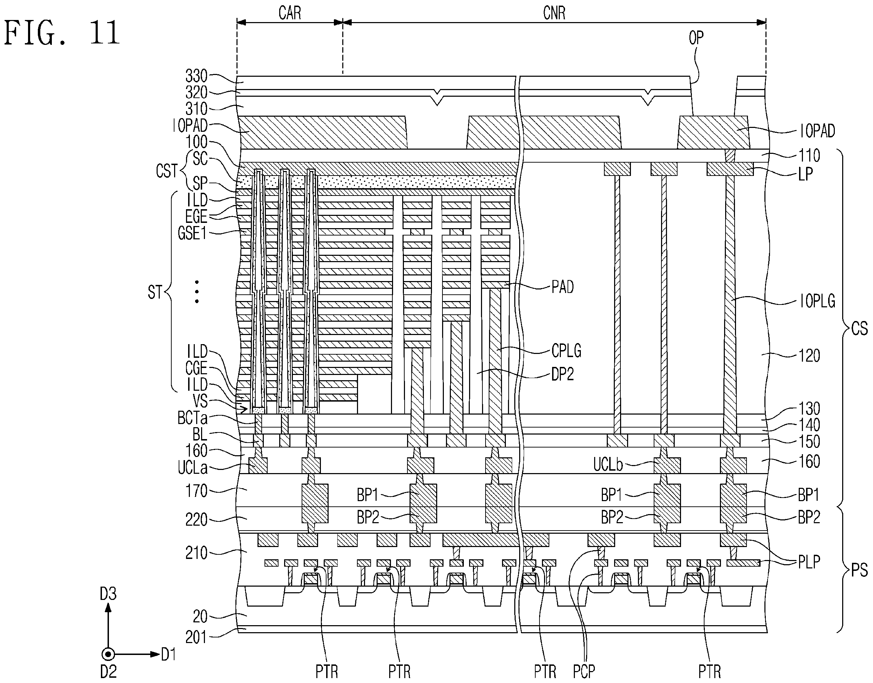

The cell array structure CS may be disposed on the lower insulating layer 50. The cell array structure CS may include a semiconductor layer 100, a source structure CST, a stacked structure ST, vertical channel structures VS, first and second dummy vertical structures DP1 and DP2, cell contact plugs CPLG (see FIG 11), through-contact plugs TPLG, bit lines BL, and conductive lines CL.

According to some embodiments, the cell strings CSTR shown in FIG. 1 may be integrated on the semiconductor layer 100. The stacked structure ST and the vertical channel structures VS may form the cell strings CSTR shown in FIG. 1.

In detail, the semiconductor layer 100 may be disposed at a top surface of the lower insulating layer 50. The semiconductor layer 100 may be formed of a semiconductor material, an insulating material, or a conductive material. The semiconductor layer 100 may include a semiconductor doped with dopants having a first conductivity type (e.g., n-type) and/or an intrinsic semiconductor that is not doped with an impurity. The semiconductor layer 100 may have a crystal structure including a single crystal structure, amorphous structure, or polycrystalline structure.

The source structure CST may be disposed between the semiconductor layer 100 and the stacked structure ST. The source structure CST may be parallel to the top surface of the semiconductor layer 100 and may extend in a first direction D1 parallel to the stacked structure ST in the cell array region CAR.

The source structure CST may include a source conductive pattern SC and a support conductive pattern SP on the source conductive pattern SC. The source conductive pattern SC may be disposed between the semiconductor layer 100 and the stacked structure ST in the cell array region CAR. The source conductive pattern SC may be formed of a semiconductor material doped with dopants having a first conductivity type (e.g., phosphorus (P) or arsenic (As)). As an example, the source conductive pattern may be formed of a polysilicon layer doped with n-type dopants.

According to some embodiments, first, second, and third insulating layers 101, 103, and 105 may be sequentially stacked and disposed between the semiconductor layer 100 and the stacked structure ST in the connection region CNR. The first, second, and third insulating layers 101, 103, and 105 may be positioned at the same or substantially the same level as the source conductive pattern SC. The second insulating layer 103 may include an insulating material different from the first and third insulating layers 101 and 105. The second insulating layer 103 may be thicker than the first and third insulating layers 101 and 105. The first, second, and third insulating layers 101, 103, and 105 may be at least one of a silicon oxide layer, a silicon nitride layer, a silicon oxynitride layer, a silicon carbide layer, or a silicon germanium layer.

The support conductive pattern SP may cover a top surface of the source conductive pattern SC in the cell array region CAR and a top surface of the third insulating layer 105 in the connection region CNR. The support conductive pattern SP may include a semiconductor doped with dopants having a first conductivity type (e.g., n-type) and/or an intrinsic semiconductor that is not doped with an impurity.

The stacked structure ST may be disposed on the source structure CST. The stacked structure ST may extend in the first direction D1 from the cell array region CAR to the connection region CNR and may have a stepped structure in the connection region CNR.

The stacked structure ST may include gate patterns EGE, GSE1, GSE2, and CGE. The gate patterns EGE, GSE1, GSE2, and CGE may include at least one material selected from, for example, a doped semiconductor (e.g. doped silicon, etc.), a metal (e.g. tungsten, copper, aluminum, etc.), a conductive metal nitride (e.g. titanium nitride, tantalum nitride, etc.) or a transition metal (e.g., titanium, tantalum, etc.). The stacked structure ST may include interlayer insulating layers ILD interposed between the gate patterns EGE, GSE1, GSE2, and CGE. The interlayer insulating layers ILD may include a silicon oxide layer and/or a low dielectric layer.

In detail, the gate patterns of the stacked structure ST may include erase control gate patterns EGE, first and second ground selection gate patterns GSE1 and GSE2, and cell gate patterns CGE. The erase control gate patterns EGE may be sequentially stacked on the support conductive pattern SP. The first and second ground selection gate patterns GSE1 and GSE2 may be disposed between the erase control gate pattern EGE and the lowest cell gate pattern CGE, and the cell gate patterns CGE may be vertically stacked on the first and second ground selection gate patterns GSE1 and GSE2.

The erase control gate patterns EGE may be adjacent to the source conductive pattern SC and may be used as gate electrodes of erase control transistors that control the erase operation of memory cells MCT (e.g., in FIG. 1). The erase control gate patterns EGE may be used as a gate electrode of the erase control transistor ECT (e.g., in FIG. 1) that generates gate induced drain leakage (GIDL).

According to embodiments, the first and second ground selection gate patterns GSE1 and GSE2 may be positioned at the same level from the top surface of the substrate 10. As shown in FIG. 7A, the first and second ground selection gate patterns GSE1 and GSE2 may extend in the first direction D1 and be spaced apart from each other in the second direction D2. The first and second ground selection gate patterns GSE1 and GSE2 may be arranged to be mirrored to each other (i.e., symmetrical), and may have an uneven side surface in a portion of the connection region CNR. The first and second ground selection gate patterns GSE1 and GSE2 may be used as gate electrodes of ground selection transistors that control the electrical connection between the common source line CSL (e.g., in FIG. 1) and the plurality of memory cells MCT (e.g., in FIG. 1).

The plurality of cell gate patterns CGE may be positioned at different levels relative to the top surface of the substrate 10. The cell gate patterns CGE may be used as the word lines WL (e.g., in FIG. 1) connected to gate electrodes of the memory cells MCT (e.g., in FIG. 1). As shown in FIG. 7B, each of the cell gate patterns CGE may include line portions LP extending side by side in the first direction D1 and connection regions CNP connecting line portions LP in the connection region CNR. Each cell gate pattern CGE may be formed of a single layer, and each cell gate pattern CGE may have at least one dummy hole DH1 in the connection portions CNP. The line portions LP of each cell gate pattern CGE may overlap the first and second ground selection gate patterns GSE1 and GSE2 when viewed in a plan view.

Although not shown in the drawing, the stacked structure ST may further include string selection gate patterns on the uppermost cell gate pattern CGE. The string selection gate patterns may be used as gate electrodes of the string selection transistors SST1 and SST2 (e.g., in FIG. 1) that control the electrical connection between the bit line BL and the vertical channel structures VS.

According to some embodiments, as shown in FIGS. 6A to 6D, each of the erase control gate patterns EGE and the cell gate patterns CGE may have a first thickness in a third direction D3. The first and second ground selection gate patterns GSE1 and GSE2 may each have a second thickness greater than the first thickness.

The interlayer insulating layers ILD of the stacked structure ST may have the same or substantially the same thickness. That is, a distance between vertically adjacent gate patterns EGE, GSE1, GSE2, and CGE may all be uniform. A thickness of each of the interlayer insulating layers ILD may be smaller than the second thickness of the first and second ground selection gate patterns GSE1 and GSE2. In one example, a distance between a first cell gate pattern CGE and a second cell gate pattern CGE that is vertically adjacent to the first cell gate pattern CGE may be equal to a distance between the first cell gate pattern CGE and a ground selection gate pattern GSE1 that is vertically adjacent to the first cell gate pattern.

The gate patterns EGE, GSE1, GSE2, and CGE of the stacked structure ST may extend from the cell array region CAR to the connection region CNR in the first direction D1. A length of the gate patterns EGE, GSE1, GSE2, and CGE of the stacked structure ST in the first direction D1 may decrease as a distance from the top surface of the substrate 10 increases.

Each of the gate patterns EGE, GSE1, GSE2, and CGE may include an electrode portion on the cell array region CAR and a pad portion PAD on the connection region CNR. The pad portions PAD of the gate patterns EGE, GSE1, GSE2, and CGE of the stacked structure ST may be thicker than the electrode portions of the cell array region CAR.

A portion of the stacked structure ST may have a stepped arrangement in the connection region CNR. In the stepped arrangement of the stacked structure ST, the pad portions PAD of the gate patterns EGE, GSE1, GSE2, and CGE of the stacked structure ST may be positioned at different positions horizontally and vertically.

A planarized insulating layer 120 may cover the pad portions PAD of the stacked structure ST in the connection region CNR. The planarized insulating layer 120 may have a substantially flat upper surface. The planarized insulating layer 120 may include one insulating layer or a plurality of stacked insulating layers.

A plurality of vertical channel structures VS may penetrate through the stacked structure ST and the source structure CST in the cell array region CAR. The vertical channel structures VS may be arranged in one direction or in a zigzag form, when viewed in a plan view.

Each of the vertical channel structures VS may include a first vertical extension extending through a lower portion of the stacked structure ST, a second vertical extension penetrating an upper portion of the stacked structure ST, and a connecting extension between the first and second vertical extensions. A diameter of the vertical channel structure VS may increase rapidly in the connecting extension.

Each of the vertical channel structures VS may include a vertical semiconductor pattern and a data storage pattern surrounding sidewalls of the vertical semiconductor pattern.

The vertical semiconductor patterns may include semiconductor materials such as silicon (Si), germanium (Ge), or mixtures thereof. The vertical semiconductor pattern containing a semiconductor material may be used as channels for the upper transistors UT1 and UT2, the memory cell transistors MCT, and the lower transistors LT1 and LT2 described with reference to FIG. 1. A portion of the sidewall of the vertical semiconductor pattern may be in contact with the source conductive pattern SC.

The data storage pattern may extend in the third direction D3 and may surround the sidewall of each vertical semiconductor pattern. The data storage pattern may be composed of one thin layer or multiple thin layers. In some example embodiments of the present disclosure, the data storage pattern is a data storage layer of a NAND flash memory device, and may include a tunnel insulating layer, a charge storage layer, and a blocking insulating layer sequentially stacked on the sidewalls of the vertical channel structure VS. For example, the charge storage layer may be a trap insulating layer, a floating gate electrode, or an insulating layer including conductive nano dots.

A first interlayer insulating layer 130 may cover upper surfaces of the vertical channel structures VS and may be disposed on the planarized insulating layer 120.

First and second separation structures SS1 and SS2 may vertically penetrate through the stacked structure ST on the semiconductor layer 100. Each of the first and second separation structures SS1 and SS2 may include an insulating layer covering a sidewall of the stacked structure ST. Each of the first and second separation structures SS1 and SS2 may have a single-layer or multi-layer structure. Top surfaces of the first and second separation structures SS1 and SS2 may be positioned at the same or substantially the same level.

The first separation structures SS1 may extend continuously from the cell array region CAR to the first connection region CNR in the first direction D1 and may be spaced apart from each other in the second direction D2 intersecting the first direction D1. Portions of the first separation structures SS1 may be in contact with the semiconductor layer 100 through the support conductive pattern SP and the source structure CST. In one example, each of the plurality of separation structures SS1, SS2 may vertically extend into the cell gate patterns CGE and may be disposed between respective ground selection gate patterns GSE1, GSE2 of the plurality of ground selection gate patterns and spaced apart from each other in the first direction in the connection region CNR.

The second separation structures SS2 may be disposed between adjacent first separation structures SS1 in the second direction D2. In the first direction D1, a length of the second separation structures SS2 may be smaller than a length of the first separation structure SS1.

The second separation structures SS2 may be disposed between the first and second ground selection gate patterns GSE1 and GSE2 and vertically penetrate through the cell gate patterns CGE and the erase control gate patterns EGE.

The second separation structures SS2 may extend continuously in the first direction D1 in the cell array region CAR and may be arranged to be spaced apart from each other at a certain distance in the first direction D1 in the connection region CNR. That is, the second separation structures SS2 may be spaced apart from each other in the first direction D1 in the connection region CNR. As another example, a plurality of second separation structures SS2 may be provided between the first separation structures SS1 and spaced apart from each other in the second direction D2.

First and second dummy vertical structures DP1 and DP2 may penetrate through the stacked structure ST in the connection region CNR. Top surfaces of the first and second dummy vertical structures DP1 and DP2 may have various shapes, such as circular, oval, or bar shapes.

The first dummy vertical structures DP1 may be disposed between the first and second ground selection gate patterns GSE1 and GSE2 in the connection region CNR, and may be disposed between the second separation structures SS2 adjacent to the first direction D1. The second dummy vertical structures DP2 may penetrate the pad portion PAD of each of the gate patterns EGE, GSE1, GSE2, and CGE. In one example, the first dummy vertical structures DP1 may be disposed between a first and second separation structures SS2 that are adjacent in the first direction and between a first ground selection gate pattern GSE1 and a second ground selection gate pattern GSE2 adjacent to the first ground selection gate pattern GSE1.

Each of the first and second dummy vertical structures DP1 and DP2 may include an insulating layer covering a sidewall of the stacked structure ST. Each of the first and second dummy vertical structures DP1 and DP2 may have a single-layer or multi-layer structure. The top surfaces of the first and second dummy vertical structures DP1 and DP2 may be positioned at the same or substantially the same level.

Each of the first and second dummy vertical structures DP1 and DP2 may include vertical portions P1a and P1b that vertically penetrate (e,g. extend vertically) through the cell gate patterns CGE and the erase control gate patterns EGE and extensions P2a and P2b that protrude horizontally from the vertical portions P1a and P1b at the same or substantially the same level as the first and second ground selection gate patterns GSE1 and GSE2. The first and second dummy vertical structures DP1 and DP2 may be formed of an insulating material, and the vertical portions P1a and P1b may have a pillar shape. The first and second dummy vertical structures DP1 and DP2 may include an air gap therein. In the first and second dummy vertical structures DP1 and DP2, top surfaces of the extensions P2a and P2b may be in contact with the interlayer insulating layers ILD.

The extensions P2a of the first dummy vertical structures DP1 may be connected to each other in the first direction D1. The extensions P2a of the first dummy vertical structures DP1 adjacent to the second separation structures SS2 may be in contact with the second separation structures SS2. There may be no boundary between the extensions P2a of the first dummy vertical structures DP1 connected to each other.

In some embodiments, the first and second ground selection gate patterns GSE1 and GSE2 may be separated and spaced apart from each other in the second direction D2 by the first dummy vertical structures DP1 and the second separation structures SS2. That is, sidewalls of the first and second ground selection gate patterns GSE1 and GSE2 facing each other may be in contact with the extensions P2a of the first dummy vertical structures DP1, which are formed of an insulating material.

The extensions P2a of the first dummy vertical structures DP1 may have the same or substantially the same thickness as the first and second ground selection gate patterns GSE1 and GSE2. The extensions P2a of the first dummy vertical structures DP1 may overlap the cell gate patterns CGE. That is, the connection portions CNP (e.g., in FIG. 7B) of the cell gate patterns CGE may surround the vertical portions P1a of the first dummy vertical structures DP1 in the connection region CNR. In one example, the cell gate patterns CGE may overlap the extension P2a of each of the first dummy vertical structures DP1.

In some embodiments, the number of first dummy vertical structures DP1 disposed between the second separation structures SS2 adjacent in the first direction D1 may be changed depending on a diameter of the vertical portion P1a and extension P2a and a distance between the second separation structures SS2. As an example, it is illustrated that three first dummy vertical structures DP1 are disposed between adjacent second separation structures SS2 in the first direction D1, but the inventive concepts are not limited thereto.

A distance S1 between the second separation structures SS2 in the first direction D1 may be greater than the sum of diameters r1 of the vertical portions P1a of the first dummy vertical structures DP1 disposed between the second separation structures SS2 adjacent in the first direction D1.

The diameter r1 of the vertical portion P1a of the first dummy vertical structure DP1 may be the same or substantially the same as the diameter of the vertical portion P1b of the second dummy vertical structure DP2. Here, the diameter may be the diameter at a top surface of each vertical portion. The diameter of the extension P2a of the first dummy vertical structure DP1 may be the same or substantially the same as the diameter of the extension P2b of the second dummy vertical structure DP2. As another example, the diameter of the vertical portion P1a of the first dummy vertical structure DP1 may be different from the diameter of the vertical portion P1b of the second dummy vertical structure DP2, and a size and shape may also be different therefrom. As another example, the second dummy vertical structure DP2 may be formed of a column-shaped vertical portion without an extension. In one example, the ground selection gate patterns GSE1, GSE2 may surround each extension P2b of the second dummy vertical structures DP2.

A second interlayer insulating layer 140 may cover the top surfaces of the first and second dummy vertical structures DP1 and DP2.

The through contact plugs TPLG may vertically penetrate through the pad portions PAD of the gate patterns EGE, GSE1, GSE2, and CGE in the connection region CNR and be connected to the peripheral circuit line PLP.

Sidewall patterns SSP formed of an insulating material may be disposed between the through contact plug TPLG and the gate patterns EGE, GSE1, GSE2, and CGE, and may be disposed below the pad portion PAD of each or the gate patterns EGE, GSE1, GSE2, and CGE. The sidewall patterns SSP may include an insulating material (e.g., silicon oxide).

Although the bit lines are omitted when viewed in a plan views, referring to FIG. 6D, the bit lines BL may extend from the cell array region CAR across the stacked structure ST in the second direction D2. The bit lines BL may be electrically connected to the vertical channel structures VS through lower and upper bit line contact plugs BCTa and BCTb.

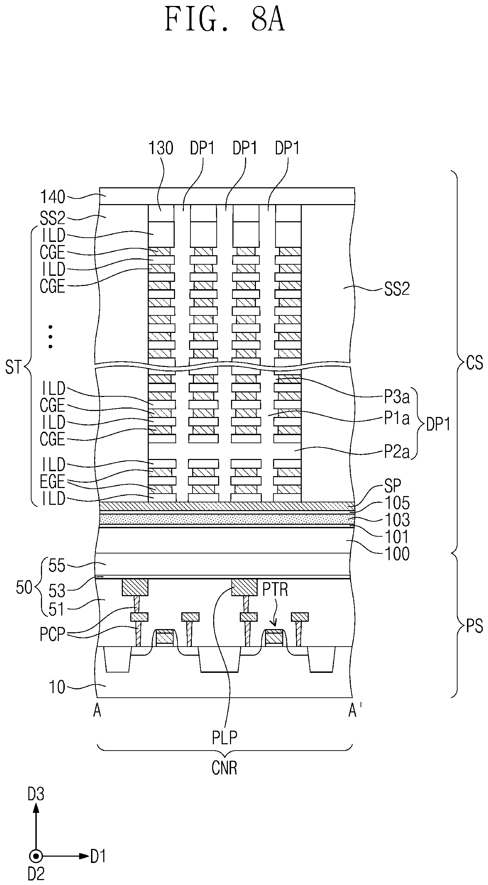

FIGS. 8A to 8E are cross-sectional views of semiconductor devices according to various some example embodiments, taken along line A-A' of FIG. 5. In this embodiment, detailed descriptions of technical features that are substantially the same or the same as those of the embodiments described with reference to FIGS. 5, 6A to 6D, 7A, and 7B may be omitted and differences will be described in detail.

Referring to FIG. 8A, first dummy vertical structures DP1 may be disposed between second separation structures SS2 adjacent in the first direction D1, and each of the first dummy vertical structures DP1 may include a vertical portion P1a vertically penetrating through the cell gate patterns CGE and the erase control gate patterns EGE, a first extension P2a protruding horizontally from the vertical portion P1a at the same level as the first and second ground selection gate patterns GSE1 and GSE2, and second extensions P3a, also referred to as cell extensions, positioned at the same level as the cell gate pattern CGE and the erase control gate patterns EGE and horizontally protruding from the vertical portion P1a.

A thickness of the first extension P2a may be the same or substantially the same as a thickness of the first and second ground selection gate patterns GSE1 and GSE2. A thickness of the second extension P3a may be the same or substantially the same as a thickness of the erase control gate patterns EGE and the cell gate patterns CGE and may be smaller than a thickness of the first extension P2a. Additionally, a horizontal distance from a sidewall of the vertical portion P1a to a sidewall of the first extension P2a may be greater than a horizontal distance from the sidewall of the vertical portion P1a to a sidewall of the second extension P3a. The sidewalls of the second extensions P3a may be spaced apart from the second separation structures SS2. In one example, diameters of the second extensions, or cell extensions, P3a may be smaller than diameters of the first extension P2a of each of the first dummy vertical structures DP1.

Although only the first dummy vertical structures DP1 are shown in FIG. 8A, the second dummy vertical structures DP2 may also have the same or substantially the same structure as the first dummy vertical structures DP1.

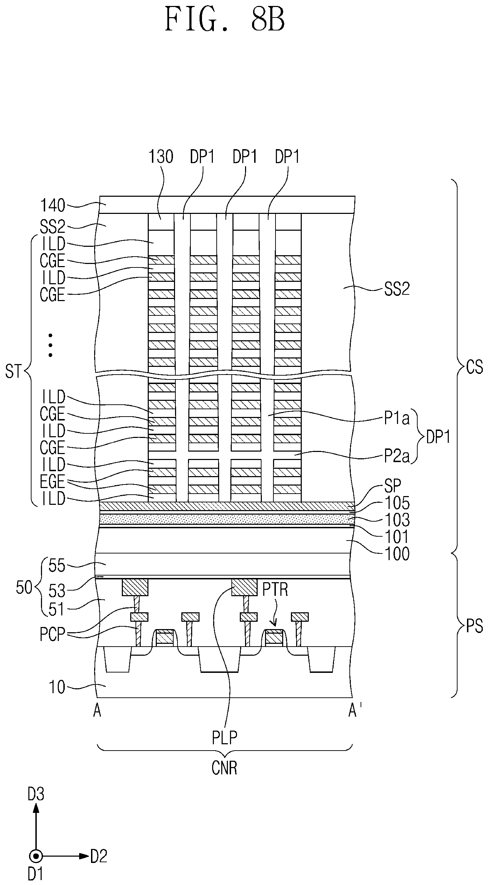

Referring to FIG. 8B, first dummy vertical structures DP1 may be disposed between adjacent second separation structures SS2 in the first direction D1, and each of the first dummy vertical structures DP1 may include the vertical portion P1a and extension portion P2a protruding horizontally from the vertical portion P1a, as described above with reference to FIGS. 6A to 6D. The extension portion P2a may be positioned at the same level as the first and second ground selection gate patterns GSE1 and GSE2 and may have a thickness the same or substantially the same as that of the first and second ground selection gate patterns GSE1 and GSE2. In the embodiment shown in FIG. 8B, the first and second ground selection gate patterns GSE1 and GSE2 may have the same or substantially the same thickness as the cell gate patterns CGE. That is, the thickness of the extension P2a may be the same or substantially the same as the thickness of each cell gate pattern CGE.

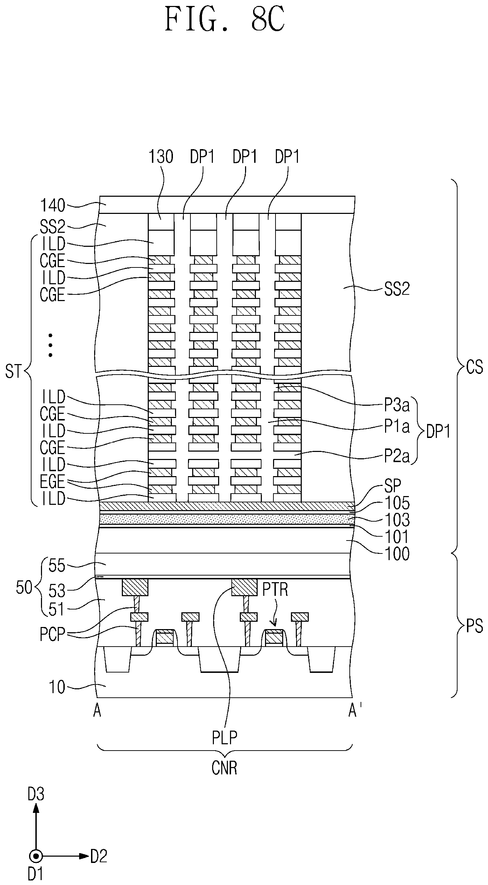

Referring to FIG. 8C, each of the first dummy vertical structures DP1 may include the vertical portion P1a and first and second extensions P2a and P3a protruding horizontally from the vertical portion P1a, as described with reference to FIG. 8A. Here, the first extension P2a may be positioned at the same level as the first and second ground selection gate patterns GSE1 and GSE2, and the second extension P3a may be positioned at the same level as the cell gate patterns CGE. In this embodiment, the first and second ground selection gate patterns GSE1 and GSE2 may have the same or substantially the same thickness as the cell gate patterns CGE, and the first extension P2a may have the same or substantially the same thickness as the second extension P3a. The first extensions P2a of the first dummy vertical structures DP1 may be connected to each other in the first direction D1 and may be in contact with the second separation structures SS2. Sidewalls of the second extensions P3a of the first dummy vertical structures DP1 may be spaced apart from each other and from the second separation structures SS2.

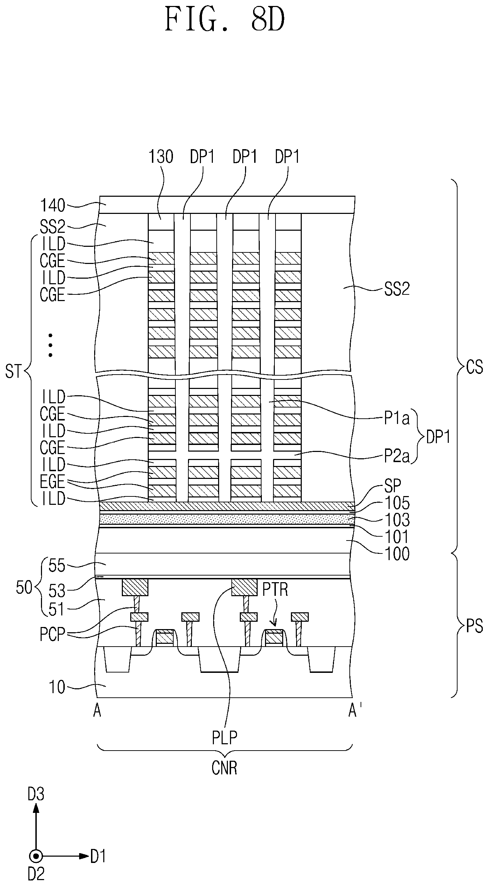

Referring to FIG. 8D, each of the first dummy vertical structures DP1 may include the vertical portion P1a and the extension P2a protruding horizontally from the vertical portion P1a, as above described with reference to FIG. 6A and FIG. 6D. Here, a thickness of the extension P2a may be smaller than a thickness of the cell gate patterns CGE. That is, a thickness of the first and second ground selection gate patterns GSE1 and GSE2 may be smaller than a thickness of each cell gate pattern CGE and may be the same or substantially the same as the thickness of the extension P2a.

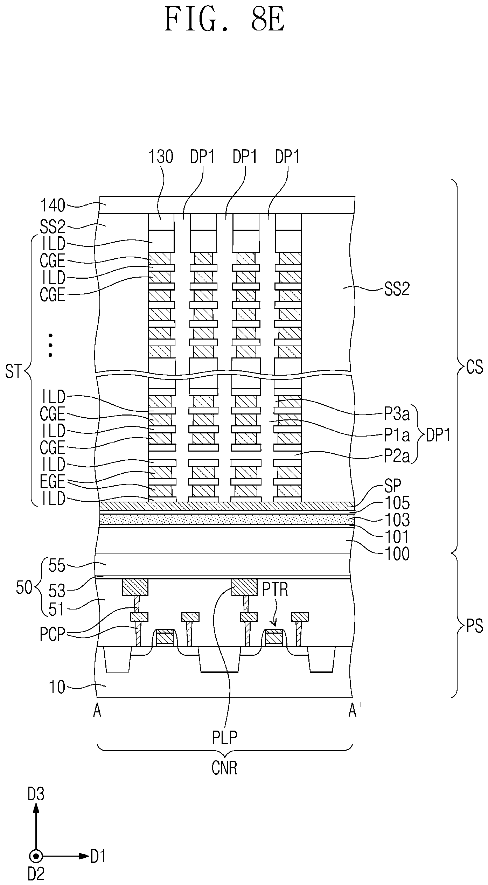

Referring to FIG. 8E, each of the first dummy vertical structures DP1 may include the vertical portion P1a and first and second extensions P2a and P3a protruding horizontally from the vertical portion P1a, as described with reference to FIG. 8A. Here, a thickness of the first extension P2a may be the same or substantially the same as a thickness of the first and second ground selection gate patterns GSE1 and GSE2, and a thickness of the second extensions P3a may be the same or substantially the same to a thickness of the cell gate patterns CGE. A thickness of the first extension P2a may be smaller than a thickness of the cell gate patterns CGE. That is, a thickness of the first extension P2a may be smaller than a thickness of each of the second extensions P3a.

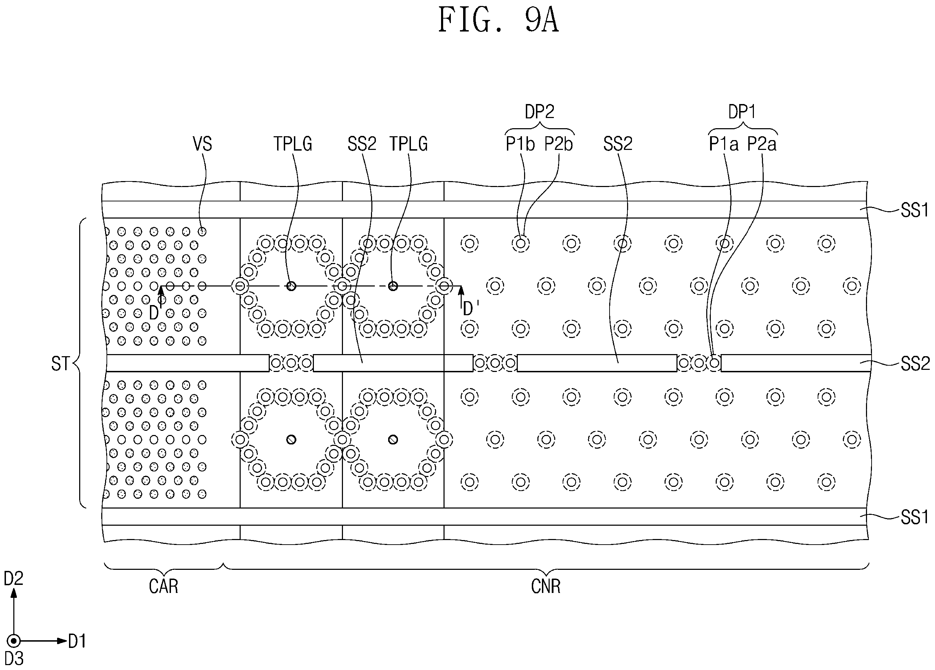

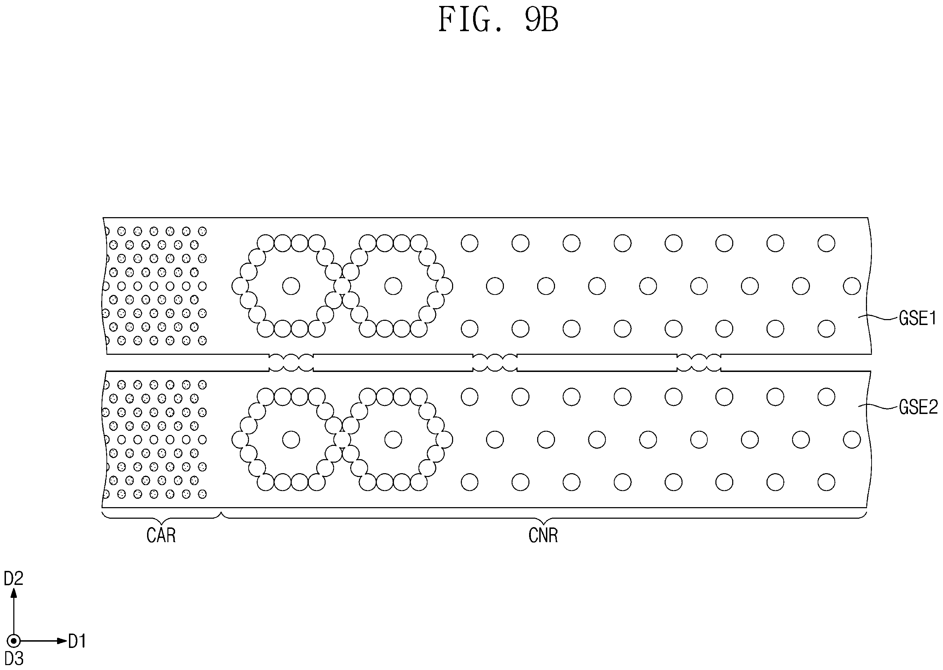

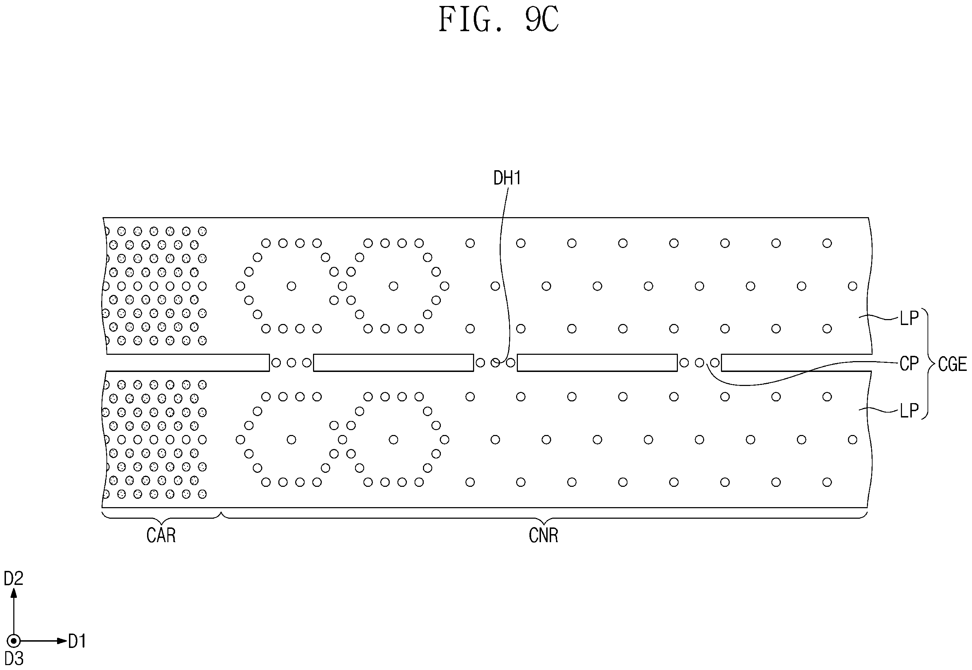

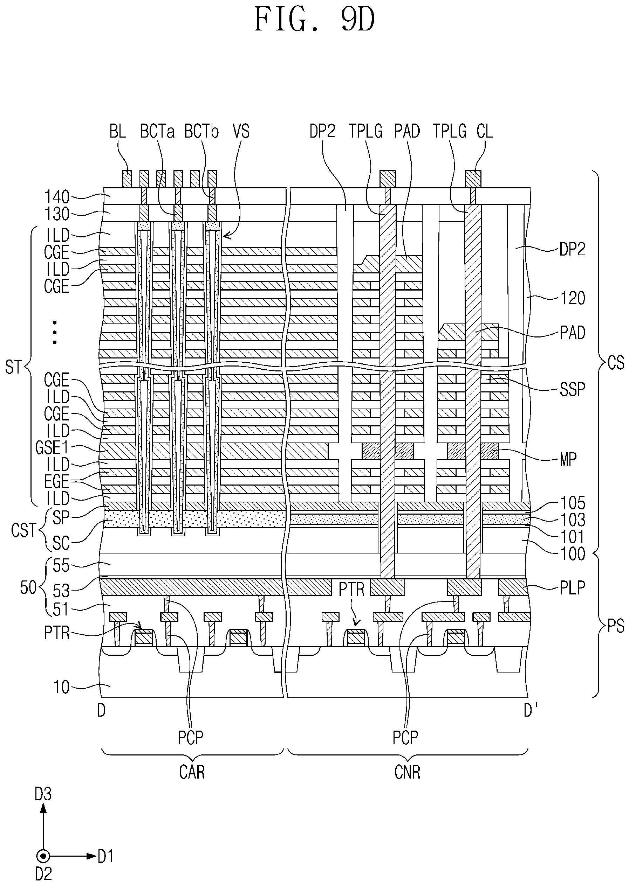

FIG. 9A is a plan view of a semiconductor device according to some example embodiments of the present disclosure. FIG. 9B is a plan view showing one cell gate pattern provided in a stacked structure according to some example embodiments of the present disclosure. FIG. 9C is a plan view showing ground selection gate patterns provided in a stacked structure according to some example embodiments of the present disclosure. FIG. 9D is a cross-sectional view of a semiconductor device according to various some example embodiments, taken along line D-D' of FIG. 9A. In this embodiment, detailed descriptions of technical features as those of the embodiments described with reference to FIGS. 5, 6A to 6D, 7A, and 7B will be omitted, and differences will be described in detail.

Referring to FIGS. 9A to 9D, first dummy vertical structures DP1 may be disposed between second separation structures SS2 adjacent to each other in the first direction D1 in the connection region CNR.

The through contact plug TPLG may be connected to and vertically penetrate through the pad portions PAD of the gate patterns EGE, GSE1, GSE2, and CGE.

Second dummy vertical structures DP2 may be disposed around each through contact plug TPLG, and extensions P2b of the second dummy vertical structures DP2 may be connected to each other around each through contact plug TPLG. A mold pattern MP may be disposed between the extensions P2b of the second dummy vertical structures DP2 and each through contact plug TPLG. That is, the mold pattern MP may be in contact with and surround a sidewall of the through contact plug TPLG at the same level as the first and second ground selection gate patterns GSE1 and GSE2.

Referring to FIG. 9B, the first and second ground selection gate patterns GSE1 and GSE2 may be arranged to be mirrored to each other (i.e., symmetrical) when viewed in a plan view. Referring to FIG. 9C, as described above, each of the cell gate patterns CGE may be a single layer and may include line portions LP and a connection portion CP connecting the line portions LP in the connection region CNR.

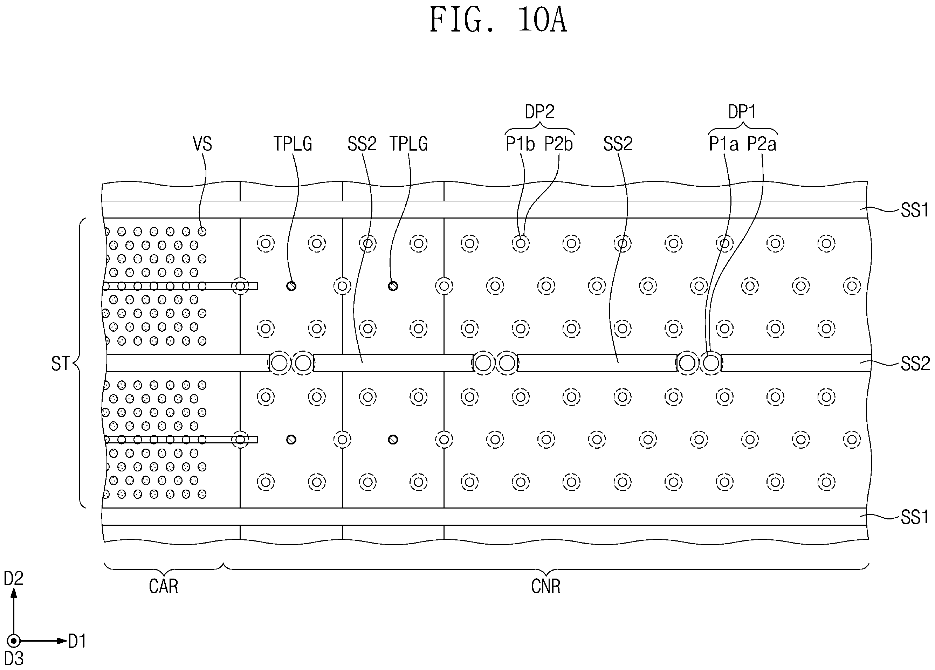

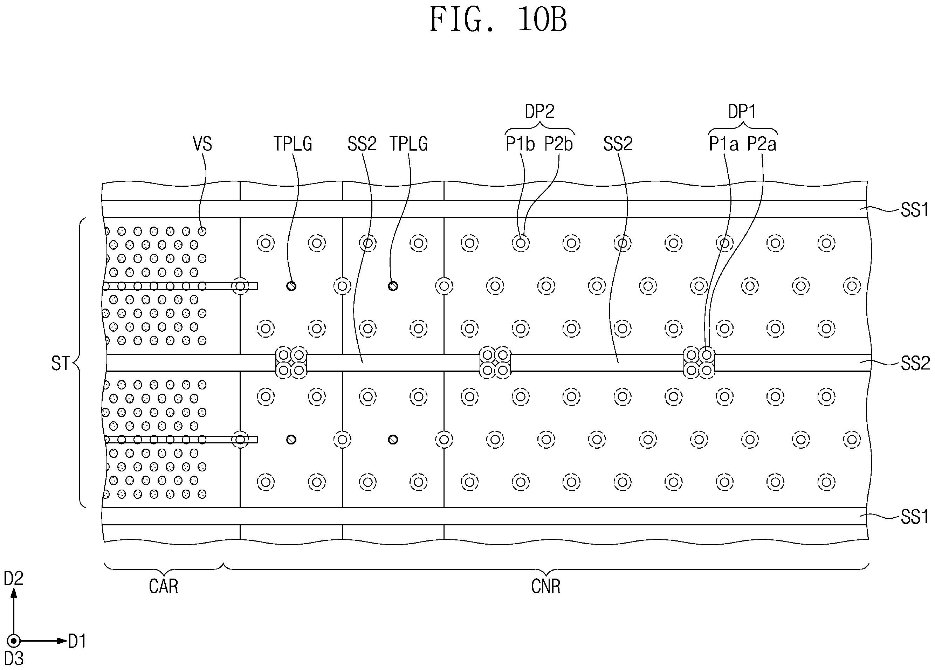

FIGS. 10A and 10B are plan views of semiconductor devices according to various example embodiments of the present disclosure. In this embodiment, detailed descriptions of technical features as those of the embodiments described with reference to FIGS. 5, 6A to 6D, 7A, and 7B will be omitted, and differences will be described in detail.

Referring to FIGS. 10A and 10B, first dummy vertical structures DP1 may be disposed between second separation structures SS2 adjacent to each other in the first direction D1 in the connection region CNR. Two dummy vertical structures DP2 may penetrate through the stacked structure ST in the connection region CNR. Here, each of the first and second dummy vertical structures DP1 and DP2 may include vertical portions P1a and P1b and extensions P2a and P2b, as described above.

Referring to FIG. 10A, a diameter of the vertical portion P1a in each first dummy vertical structure DP1 may be larger than a diameter of the vertical portion P1b in each second dummy vertical structure DP2. According to this embodiment, two first dummy vertical structures DP1 may be disposed between second separation structures SS2 adjacent to each other in the first direction D1.

Referring to FIG. 10B, the first dummy vertical structures DP1 may be arranged in a matrix form between the second separation structures SS2 adjacent to each other in the first direction D1. At least three or more extensions P2a of the first dummy vertical structures DP2 may be connected to each other to form a circular or polygonal shape between the second separation structures SS2.

FIG. 11 is a cross-sectional view of a semiconductor device according to some example embodiments of the present disclosure.

Referring to FIG. 11, a semiconductor device according to embodiments of the inventive concept may have a chip to chip (C2C) structure. The C2C structure may formed of fabricating an upper chip including a cell array structure CS on a first wafer, fabricating a lower chip including a peripheral circuit structure PS on a second wafer different from the first wafer, and connecting the upper chip and the lower chip to each other by bonding. As an example, the bonding method may refer to a method of electrically connecting a bonding metal formed on the uppermost metal layer of the upper chip and a bonding metal formed on the uppermost metal layer of the lower chip. For example, when the bonding metal is formed of copper (Cu), the bonding method may be a Cu-to-Cu bonding method, and the bonding metal may be formed of aluminum (Al) or tungsten (W).

The cell array structure CS may include a memory cell array including memory cells arranged three-dimensionally on a semiconductor layer 100. A memory cell array may be electrically connected to the first bonding pads BP1.

In detail, the cell array structure CS may include the semiconductor layer 100, a source structure CST, a stacked structure ST, vertical channel structures VS, bit lines BL, cell contact plugs CPLG, and an input/output contact plug IOPLG.

The cell array structure CS may include a cell array region CAR and a connection region CNR.

The semiconductor layer 100 of the cell array structure CS may be disposed on a top surface of a lower insulating layer 110 in the cell array region CAR and connection region CNR. The semiconductor layer 100 may be formed of a semiconductor material, an insulating material, or a conductive material.

The source structure CST may be disposed on the semiconductor layer 100. The source structure CST may include a source conductive pattern SC and a support conductive pattern SP on the source conductive pattern SC. The source structure CST may be parallel to a top surface of the semiconductor layer 100 and may extend in a first direction D1 parallel to the stacked structure ST in the cell array region CAR and connection region CNR.

The source conductive pattern SC may be formed of a semiconductor material doped with dopants having a first conductivity type (e.g., phosphorus (P) or arsenic (As)). As an example, the source conductive pattern may be formed of a semiconductor layer 100 doped with n-type dopants.

The support conductive pattern SP may cover a top surface of the source conductive pattern SC and may include a semiconductor doped with dopants having a first conductivity type (e.g., n-type) and/or an intrinsic semiconductor in a state where no impurities are doped. Portions of the support conductive pattern SP in the cell array region CAR may penetrate the source conductive pattern SC to be in contact with the semiconductor layer 100.

A pad conductive pattern LP may be spaced apart from a sidewall of the semiconductor layer 100 and disposed in the connection region CNR. The pad conductive pattern LP may be connected to the input/output pad IOPAD provided on the insulating layer 110.

A stacked structure ST may be disposed on the source structure CST. As described above, the stacked structure ST may include gate patterns EGE, GSE1, GSE2 and CGE and interlayer insulating layers ILD alternately stacked in a vertical direction.

Each of the gate patterns EGE, GSE1, GSE2, and CGE may include an electrode portion on the cell array region CAR and a pad portion PAD on the first connection region CNR1, as described with reference to FIG. 7A. The gate patterns EGE, GSE1, GSE2, and CGE may be stacked on the source structure CST to have a step structure in the connection region CNR. The pad portions PAD of the gate patterns EGE, GSE1, GSE2, and CGE may be positioned at different positions horizontally and vertically. The cell contact plugs CPLG may be respectively connected to the pad portions PAD of the gate patterns EGE, GSE1, GSE2, and CGE.

A plurality of vertical channel structures VS may penetrate through the stacked structure ST in the cell array region CAR. As described above, each of the vertical channel structures VS may include a vertical semiconductor pattern and a data storage pattern surrounding sidewalls of the vertical semiconductor pattern. Each of the vertical channel structures VS may include a lower vertical structure penetrating through a lower region of the stacked structure ST and an upper vertical structure penetrating through an upper region of the stacked structure ST.

Although not shown in FIG 11, first dummy vertical structures DP1 may be disposed between the first and second ground selection gate patterns GSE1 and GSE2 positioned at the same level. Furthermore, as described above, the second dummy vertical structures DP2 may penetrate through the pad portions PAD of the gate patterns EGE, GSE1, GSE2, and CGE in the first connection region CNR1.

A planarized insulating layer 120 may cover the stepped arrangement of the stacked structure ST. The planarized insulating layer 120 may have a substantially flat upper surface. The planarized insulating layer 120 may include one insulating layer or a plurality of stacked insulating layers. Interlayer insulating layers 130, 140, 150, 160, and 170 may be sequentially stacked on the planarized insulating layer 120. The interlayer insulating layers 130, 140, 150, 160, and 170 may include an insulating material such as silicon oxide or silicon nitride.

The cell contact plugs CPLG may penetrate through the first and second interlayer insulating layers 130 and 140 and the planarized insulating layer 120 and be respectively connected to pad portions of the gate patterns EGE, GSE1, GSE2, and CGE. Vertical lengths of the cell contact plugs CPLG may be reduced as they become adjacent to the cell array region CAR. Top surfaces of the cell contact plugs CPLG may be substantially coplanar.

The input/output contact plugs IOPLG may penetrate through the first and second interlayer insulating layers 130 and 140 and the planarized insulating layer 120 and be connected to the pad conductive pattern LP. The input/output contact plugs IOPLG may be electrically connected to an input/output pad IOPAD through the pad conductive pattern LP.

The bit lines BL may be disposed on the second interlayer insulating layer 140 in the cell array region CAR and may extend in a second direction D2 across the stacked structure ST. The bit lines BL may be electrically connected to the vertical channel structures VS through lower and upper bit line contact plugs BCTa and BCTb.

First and second upper conductive lines UCLa and UCLb may be disposed in the fourth interlayer insulating layer 160. The first upper conductive lines UCLa may be electrically connected to the bit lines BL in the cell array region CAR. The second upper conductive lines UCLb may be electrically connected to lower conductive lines in the connection region CNR.

First bonding pads BP1 may be provided in the uppermost interlayer insulating layer 170. The first bonding pads BP1 may be electrically connected to the first and second upper conductive lines UCLa and UCLb. The first bonding pads BP1 may be formed of aluminum, copper, or tungsten.

The peripheral circuit structure PS may be formed on the semiconductor substrate 20 and may include peripheral circuits PTR that control the memory cell array, and peripheral interlayer insulating layers 210 and 220 covering the peripheral circuits PTR. The peripheral circuits PTR may be integrated on a top surface of the semiconductor substrate 20. A surface insulating layer 201 may be provided on a back surface of the semiconductor substrate 20.

The peripheral circuits PTR may be row and column decoders, page buffers, and control circuits. In detail, the peripheral circuits PTR may include NMOS and PMOS transistors. Peripheral circuit lines PLP may be electrically connected to the peripheral circuits PTR through peripheral contact plugs PCP.

Peripheral interlayer insulating layers 210 and 220 may be provided on a top surface of the semiconductor substrate 20. The peripheral interlayer insulating layers 210 and 220 may cover the peripheral circuits PTR, peripheral contact plugs PCP, and peripheral circuit lines PLP on the semiconductor substrate 10. The peripheral contact plugs PCP and peripheral circuit lines PLP may be electrically connected to the peripheral circuits PTR. The peripheral interlayer insulating layers 210 and 220 may include a silicon oxide layer, a silicon nitride layer, a silicon oxynitride layer, and/or a low dielectric layer.

Second bonding pads BP2 may be provided in the uppermost peripheral interlayer insulating layer 220 corresponding to the first bonding pads BP1. The second bonding pads BP2 may be electrically connected to the peripheral circuits PTR through peripheral circuit lines PLP and peripheral contact plugs PCP.

The second bonding pads BP2 may be electrically and physically connected to the first bonding pads BP1 through a bonding method. That is, the second bonding pads BP2 may be in direct contact with the first bonding pads BP1.

The second bonding pads BP2 may include the same metal material as the first bonding pads BP1. The second bonding pads BP2 may have the same or substantially the same shape, same width, or same area as the first bonding pads BP1.

The input/output pads IOPAD may be disposed on a lower surface of the insulating layer 110 of the cell array structure CS. A capping insulating layer 310 may be disposed on the lower surface of the lower insulating layer 110, the capping insulating layer 310 may cover the input/output pads IOPAD.

A protective layer 320 and a passivation layer 330 may be formed sequentially on the entire surface of the capping insulating layer 310. The protective layer 320 may be, for example, a silicon nitride layer or a silicon oxynitride layer. The passivation layer 330 may be, for example, a polyimide-based material such as photo sensitive polyimide (PSPI).

The protective layer 320 and the passivation layer 330 may have a pad opening OP that exposes a portion of the input/output pads IOPAD.

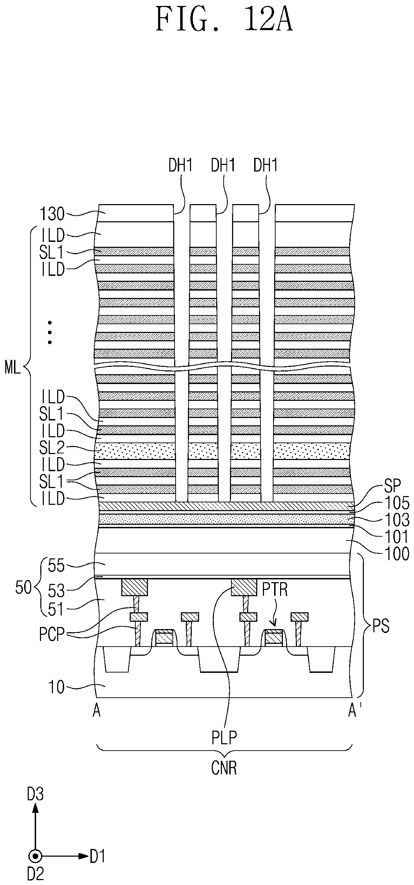

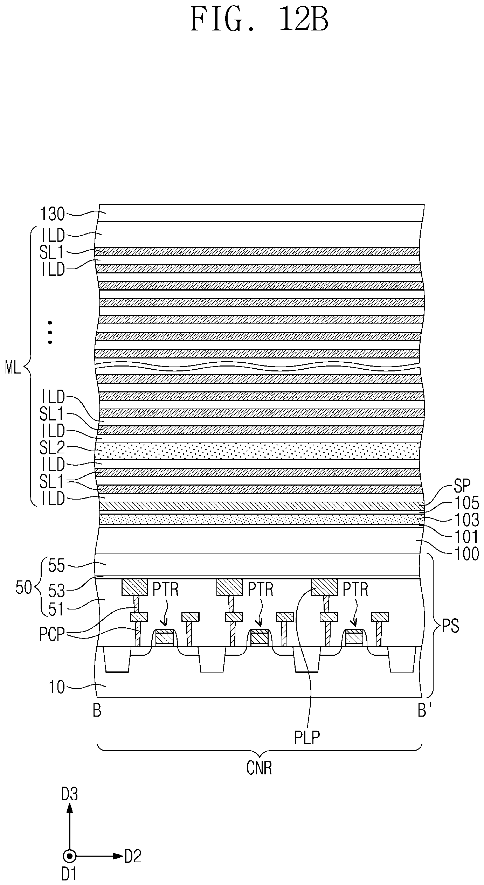

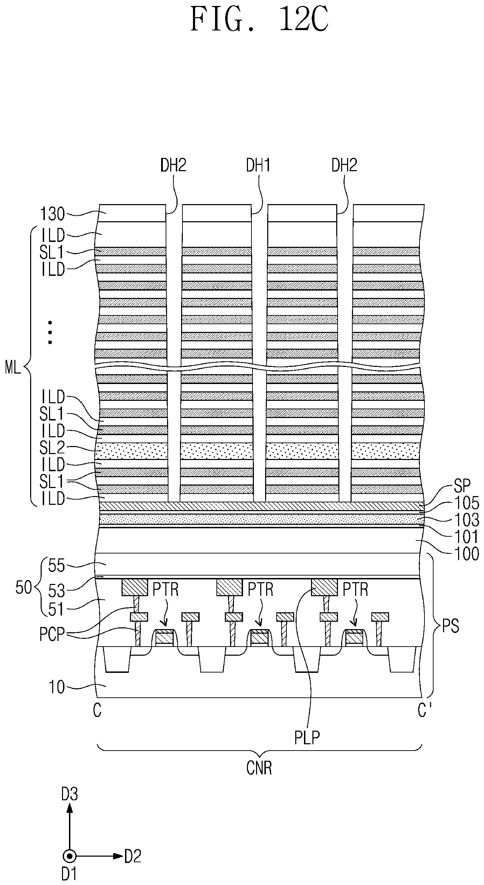

FIGS. 12A to 18A are diagrams for explaining a method of manufacturing a semiconductor device according to some example embodiments and show cross-sections taken along line A-A' of FIG. 5. FIGS. 12B to 18B are diagrams for explaining a method of manufacturing a semiconductor device according to some example embodiments and show cross-sections taken along line B-B' of FIG. 5A. FIGS. 12C to 18C are diagrams for explaining a method of manufacturing a semiconductor device according to some example embodiments and show cross-sections taken along line C-C' of FIG. 5A.

Referring to FIGS. 5, 12A, 12B, and 12C, a peripheral circuit structure PS may be formed on a semiconductor substrate 10.

The forming of the peripheral circuit structure PS may include forming peripheral circuits PTR on the semiconductor substrate 10, forming peripheral interconnection structures PCP and PLP connected to the peripheral circuits PTR, and forming a lower insulating layer 50.

Row and column decoders, page buffers, and control circuits may be formed on the semiconductor substrate 10 as peripheral circuits PTR. Here, the peripheral circuits PTR may include MOS transistors that use the semiconductor substrate 10 as a channel.

The lower insulating layer 50 may include one insulating layer or a plurality of stacked insulating layers covering the peripheral circuits PTR. The lower insulating layer 50 may include a first lower insulating layer 51, a second lower insulating layer 55, and an etch stop layer 53 between the first and second lower insulating layers 51 and 55. The lower insulating layer 50 may include, for example, a silicon oxide layer, a silicon nitride layer, a silicon oxynitride layer, and/or a low dielectric layer.

The forming of the peripheral interconnection structures may include forming peripheral contact plugs PCP penetrating portions of the lower insulating layer 50 and forming peripheral circuit lines PLP connected to the peripheral contact plugs PCP.

A semiconductor layer 100 may be formed on the peripheral circuit structure PS. The semiconductor layer 100 may be formed by depositing a semiconductor material. The semiconductor layer 100 may include at least one of, for example, silicon (Si), germanium (Ge), silicon germanium (SiGe), gallium arsenide (GaAs), indium gallium arsenide (InGaAs), aluminum gallium arsenide (AlGaAs), or a mixture thereof. The semiconductor layer 100 may include a semiconductor doped with impurities and/or an intrinsic semiconductor that is not doped with impurities. The semiconductor layer 100 may have a crystal structure including a single crystal structure, an amorphous structure, or a polycrystalline structure.

A first insulating layer 101, a second insulating layer 103, and a third insulating layer 105 may be sequentially stacked on the semiconductor layer 100. The first insulating layer 101 may be formed by thermally oxidizing a surface of the semiconductor layer 100 or by depositing a silicon oxide layer. The second insulating layer 103 may be formed of a material that has an etch selectivity with respect to the first insulating layer 101 and the third insulating layer 105. As an example, the second insulating layer 103 may be at least one of a silicon nitride layer, a silicon oxynitride layer, a silicon carbide layer, or a silicon germanium layer. The third insulating layer 105 may be formed by depositing a silicon oxide layer.

A support conductive layer SP may be deposited on the third insulating layer 105 to have a uniform thickness. The support conductive layer SP may fill openings of the first insulating layer 101, the second insulating layer 103, and the third insulating layer 105 in the cell array region CAR. The support conductive layer SP may be in direct contact with the semiconductor layer 100 within the openings. The support conductive layer SP may be a polysilicon layer doped with n-type dopants and/or carbon (C).

A mold structure ML may be formed on the support conductive layer SP. The mold structure ML may include interlayer insulating layers ILD and first and second sacrificial layers SL1 and SL2 that are alternately stacked vertically.

In the mold structure ML, the first and second sacrificial layers SL1 and SL2 may be formed of a material that may be etched with an etch selectivity with respect to the insulating layers ILD. For example, the first and second sacrificial layers SL1 and SL2 may be formed of an insulating material different from the interlayer insulating layers ILD. For example, the first and second sacrificial layers SL1 and SL2 may be formed of a silicon nitride layer, and the interlayer insulating layers ILD may be formed of a silicon oxide layer. The second sacrificial layer SL2 is disposed between the vertically adjacent first sacrificial layers SL1 and is a layer to be replaced by first and second ground selection gate patterns during a subsequent manufacturing process.

For example, the first and second sacrificial layers SL1 and SL2 may be formed of the same material, but the second sacrificial layer SL2 may be deposited thicker than the first sacrificial layers SL1. As another example, the second sacrificial layer SL2 may have the same or substantially the same thickness as the first sacrificial layers SL1 but may be formed of materials with different etch selectivity. As another example, the thickness of the second sacrificial layer SL2 may be smaller than the thickness of each of the first sacrificial layers SL1. For example, in an isotropic etching process for removing the first and second sacrificial layers SL1 and SL2, the etch rate of the second sacrificial layer SL2 may be greater than that of the first sacrificial layers SL1.

The interlayer insulating layers ILD and the first and second sacrificial layers SL1 and SL2 may be deposited using a thermal chemical vapor deposition (Thermal CVD), plasma enhanced chemical vapor deposition (CVD), physical chemical vapor deposition (physical CVD), or atomic layer deposition (ALD) process. The interlayer insulating layers ILD and the first and second sacrificial layers SL1 and SL2 may be deposited in-situ. In embodiments, the interlayer insulating layers ILD have the same or substantially the same thickness and may be deposited alternately with the first and second sacrificial layers SL1 and SL2.

After forming the mold structure ML, vertical channel structures VS (e.g., see FIGS. 5 and 6D) may be formed in the cell array region CAR, and after forming the vertical channel structures VS, a first interlayer insulating layer 130 may be formed covering upper surfaces of the vertical channel structures VS.

Referring to FIGS. 5, 12A, 12B, and 12C, first and second dummy holes DH1 and DH2 may be formed in the connection region CNR.

The forming of the first and second dummy holes DH1 and DH2 may including forming a mask pattern (not shown) on the first interlayer insulating layer 130 and anisotropically etching the mold structure ML using the mask pattern (not shown) as an etch mask to expose the support conductive layer SP.

The first dummy holes DH1 may be formed at regular intervals in the connection region CNR in the first direction D1. The second dummy holes DH2 may be formed to be spaced apart from the first dummy holes DH1 in the connection region CNR, and may be arranged in a zigzag shape in the first direction D1 or arranged in a honeycomb shape when viewed in a plan view.

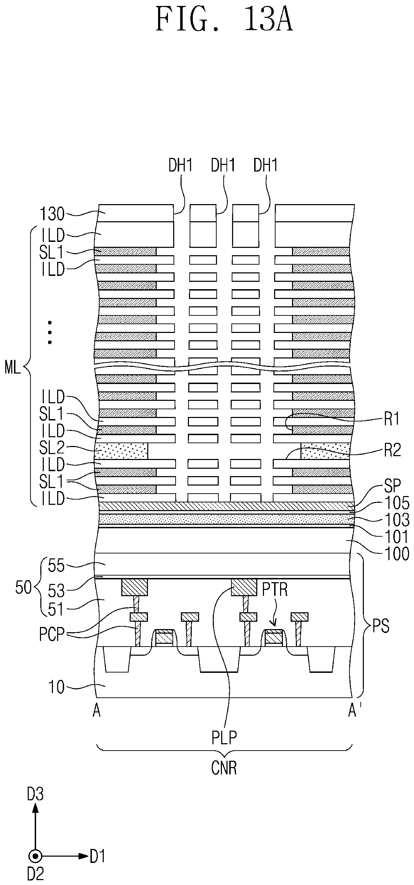

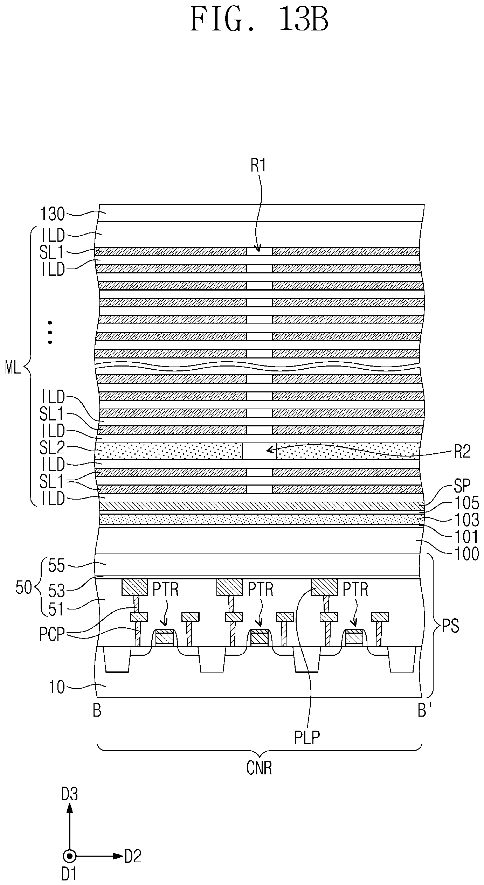

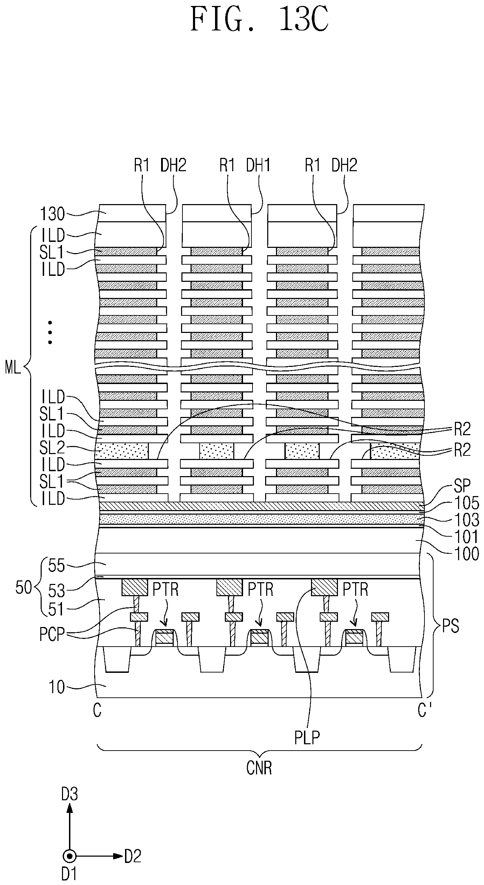

Referring to FIGS. 5, 13A, 13B, and 13C, portions of the first and second sacrificial layers SL1 and SL2 exposed to the first and second dummy holes DH1 and DH2 may be isotropically etched. The isotropic etching process may use an etching recipe that has etch selectivity for the interlayer insulating layers ILD. Accordingly, portions of the first sacrificial layers SL1 exposed to the first and second dummy holes DH1 and DH2 may be etched to form first recess regions R1, and a portion of the second sacrificial layer SL2 exposed thereto may be etched to form second recess regions R2.

As a thickness of the second sacrificial layer SL2 is greater than a thickness of the first sacrificial layer SL1, an etch rate of the second sacrificial layer SL2 may be faster than an etch rate of the first sacrificial layer SC1 in the process of isotropically etching the first and second sacrificial layers SL1 and SL2. Accordingly, in a horizontal direction, an etch depth of the second recess region R2 may be greater than an etch depth of the first recess region R1. In addition, when the first and second sacrificial layers SL1 and SL2 are isotropically etched, the second recess regions R2 in the first dummy holes DH1 adjacent to each other in the first direction D1 may be connected to each other in the first direction D1.

As another example, when the thickness of the second sacrificial layer SL2 is smaller than the thickness of the first sacrificial layer SL1, the etch depth of the second recess region R2 may be smaller than the etch depth of the first recess region R1.

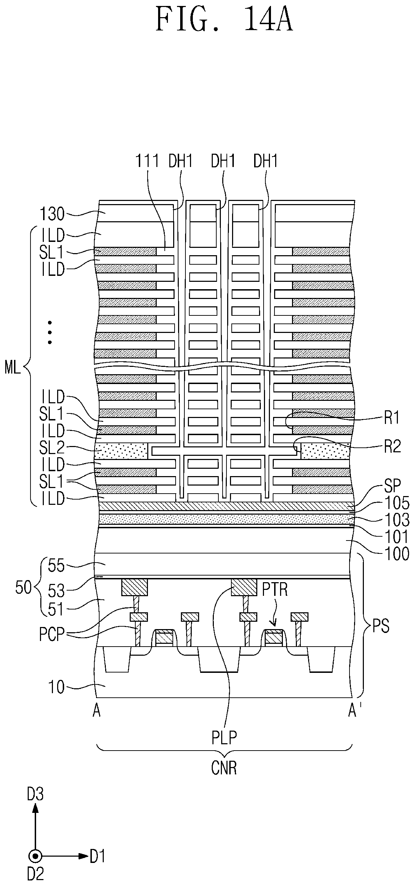

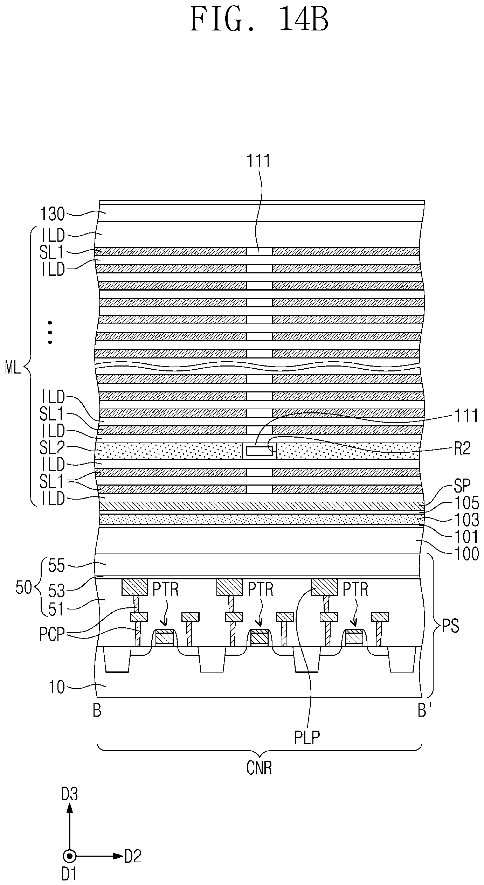

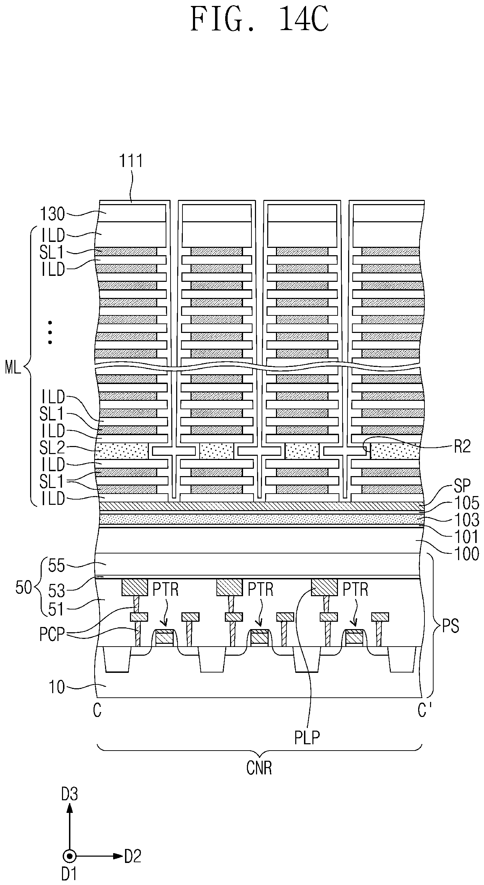

Referring to FIGS. 5, 14A, 14B, and 14C, a third sacrificial layer 111 may be formed to cover the first and second recess regions R1 and R2 and the first and second dummy holes DH1 and DH2 with a uniform thickness. The third sacrificial layer 111 may be formed of an insulating material that has an etch selectivity with respect to the interlayer insulating layers ILD. The third sacrificial layer 111 may include the same material as the first and second sacrificial layers SL1 and SL2. For example, the third sacrificial layer 111 may be a silicon nitride layer.

A thickness of the third sacrificial layer 111 may be less than half a diameter of the first and second dummy holes DH1 and DH2. The third sacrificial layer 111 may completely fill the first recess regions R1 and cover an inner wall of the second recess region R2 with a substantially uniform thickness.

As another example, when the thickness of the second sacrificial layer SL2 is smaller than the thickness of the first sacrificial layer SL1, the third sacrificial layer 111 may be formed of the same insulating material (e.g., silicon oxide) as the interlayer insulating layers ILD, and the third sacrificial layer 111 may completely fill the second recess region R2 and cover the inner walls of the first recess regions R1 with a substantially uniform thickness.

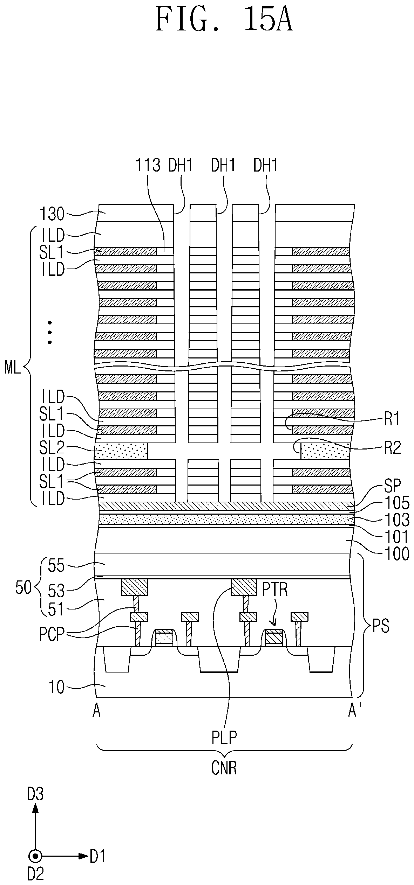

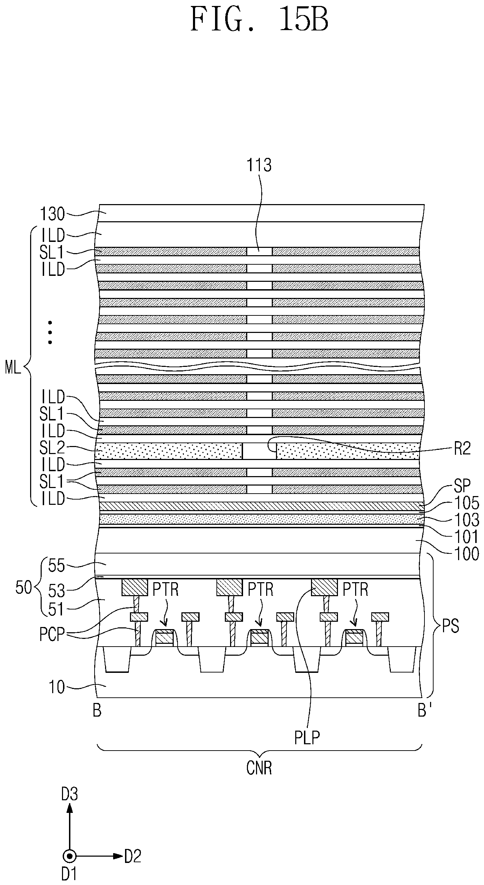

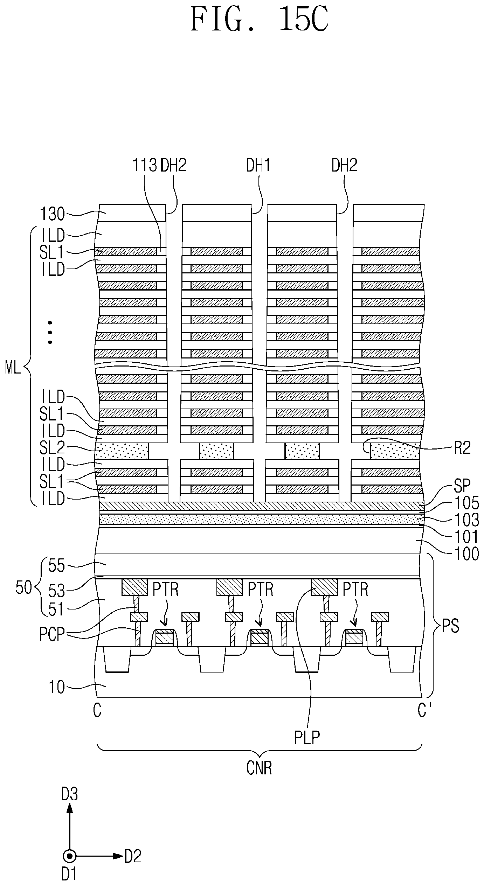

Referring to FIGS. 5, 15A, 15B, and 15C, an etching process is performed on the third sacrificial layer 111 to form third sacrificial patterns 113 locally within the first recess regions R1.

The forming of the third sacrificial patterns 113 may include performing an isotropic etching process on the third sacrificial layer to expose the sidewalls of the interlayer insulating layers ILD in the first and second dummy holes DH1 and DH2. As the isotropic etching process is performed on the third sacrificial layer 111, the third sacrificial layer 111 may be removed from the second recess region R2 and the sidewall of the second sacrificial layer SL2 may be exposed again.

As another example, when the thickness of the second sacrificial layer SL2 is smaller than the thickness of the first sacrificial layer SL1, the third sacrificial layer 111 formed of silicon oxide may be removed from the first recess regions R1 to expose the sidewalls of the first sacrificial layers SL1 again, and then the third sacrificial patterns 113 may be formed locally in the first recess regions R1.

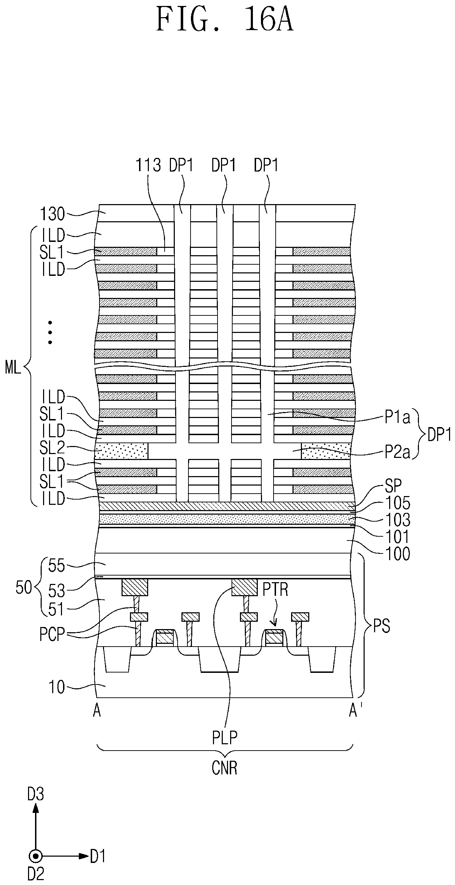

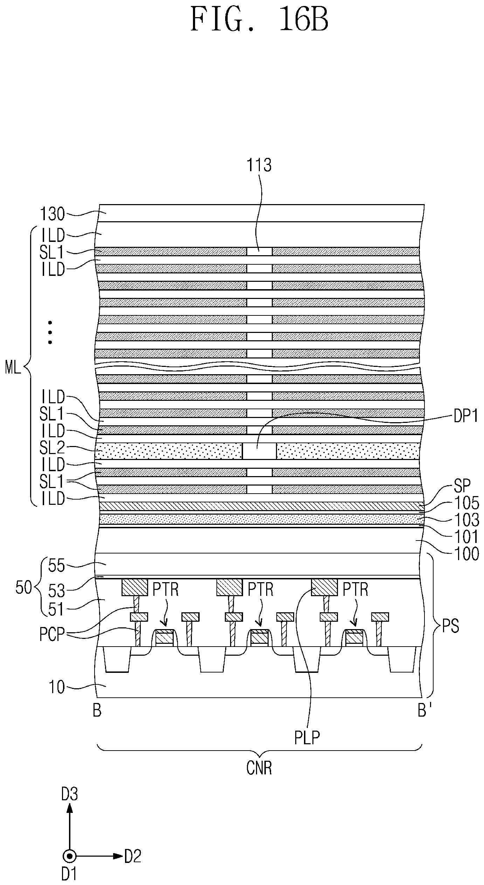

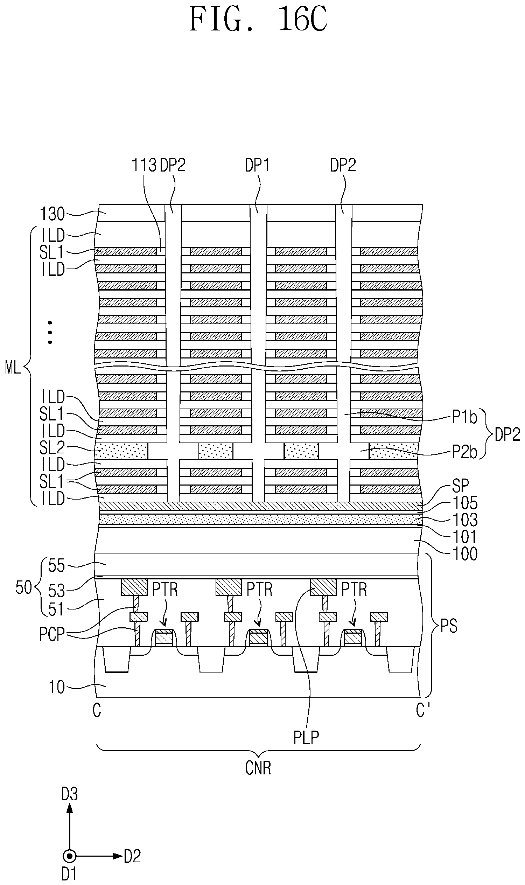

Referring to FIGS. 5, 16A, 16B, and 16C, after the forming of the third sacrificial patterns 113, first and second dummy vertical structures DP1 and DP2 may be formed to fill the second recess region R2 and the first and second dummy holes DH1 and DH2.

The forming of the first and second dummy vertical structures DP1 and DP2 may include depositing an insulating material having etch selectivity with respect to the first sacrificial layers SL1 and the third sacrificial patterns 113 in the second recess region R2 and in the first and second dummy holes DH1 and DH2, and performing a planarization process to expose a top surface of the first interlayer insulating layer 130. The first and second dummy vertical structures DP1 and DP2 may include, for example, a silicon oxide layer, a silicon nitride layer, a silicon oxynitride layer, and/or a low dielectric layer. An air gap may be formed while depositing the insulating material in the second recess region R2 and the first and second dummy holes DH1 and DH2. That is, the first and second dummy vertical structures DP1 and DP2 may have air gaps within the first and second dummy holes DH1 and DH2.

The first and second dummy vertical structures DP1 and DP2 may completely fill the second recess region R2. The first dummy vertical structures DP1 adjacent to each other may be horizontally connected to each other at the same level as the second sacrificial layer SL. Each of the first and second dummy vertical structures DP1 and DP2 may include vertical portions P1a and P1b filled in the first and second dummy holes DH1 and DH2 and extensions P2a and P2b filled in the second recess region R2.

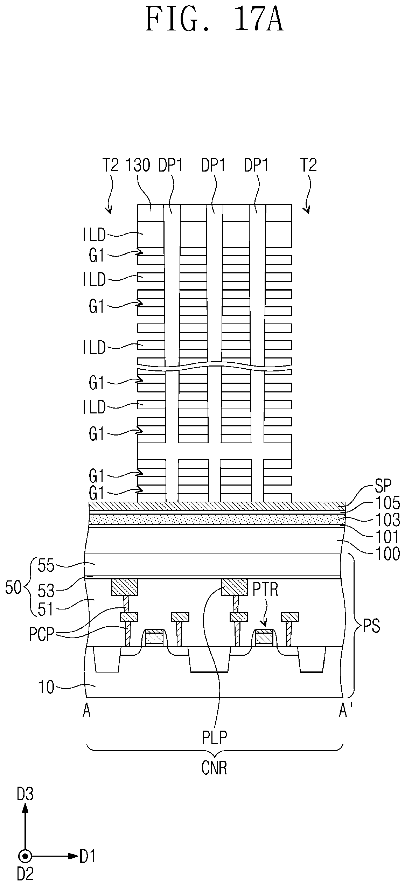

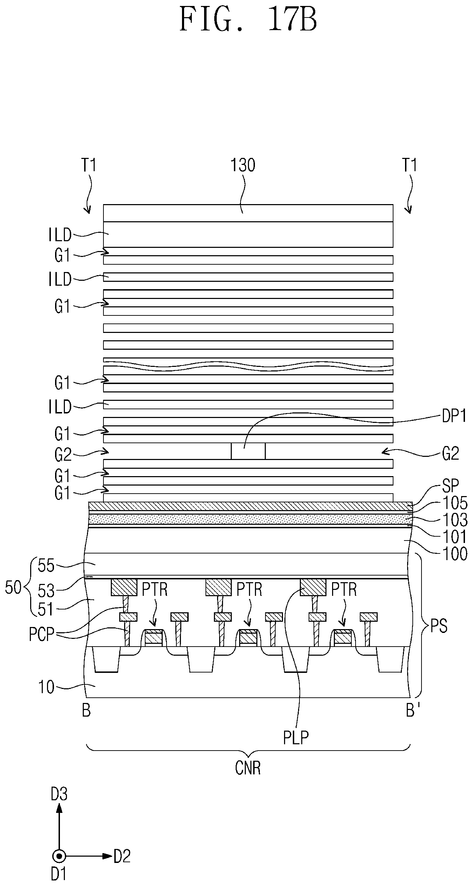

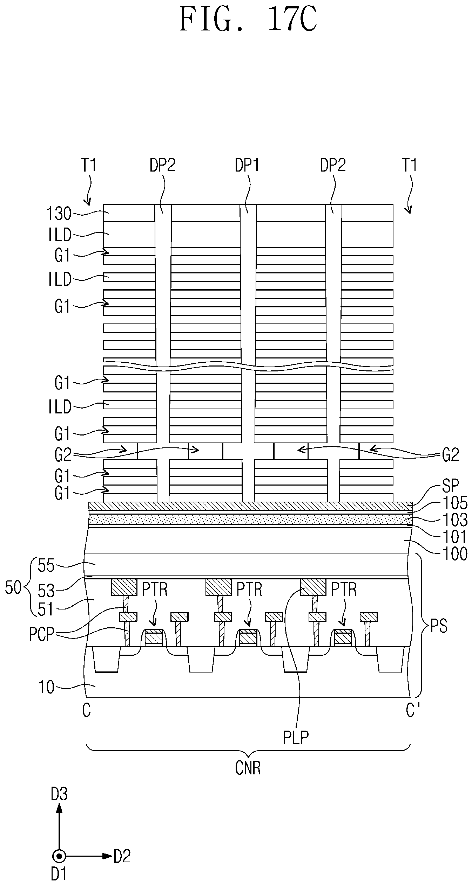

Referring to FIGS. 5, 17A, 17B, and 17C, first and second isolation trenches T1 and T2 may be formed through the mold structure to expose the support semiconductor layer SP. The forming of the first and second separation trenches T1 and T2 may include anisotropically etching the first interlayer insulating layer 130 and the mold structure ML, and the support semiconductor layer SP may be used as an etch stop layer during the anisotropic etching process.

The first and second separation trenches T1 and T2 may extend from the cell array region CAR to the connection region CNR in the first direction D1. The second separation trenches T2 may be shorter than the first separation trenches T1 in the first direction D 1.

The first separation trenches T1 may continuously extend from the cell array region CAR to the connection region CNR in the first direction D1 and may be spaced apart from each other in the second direction D2.

The second separation trenches T2 may penetrate through the mold structure between the first separation trenches T1 adjacent to each other in the second direction D2. The second separation trenches T2 may extend in the first direction D1 in the cell array region CAR and may be formed at a certain distance from the connection region CNR in the first direction D1.

The second separation trenches T2 may be formed in the first direction D1 with certain first dummy vertical structures DP1 interposed therebetween. The second separation trenches T2 may expose the extensions P2a and P2b of the first dummy vertical structures DP1.

Subsequently, the first and second sacrificial layers SL1 and SL2 and third sacrificial patterns 113 exposed in the first and second isolation trenches T1 and T2 may be removed to form first and second gate regions G1 and G2. The first and second gate regions G1 and G2 may be formed by isotropically etching the sacrificial layers using an etch recipe with etch selectivity with respect to the interlayer insulating layers ILD, the vertical channel structures VS, and the first and second dummy vertical structures DP1 and DP2. Here, the first and second sacrificial layers SL1 and SL2 and the third sacrificial patterns 113 may be completely removed through the isotropic etching process.

The first gate regions G1 may expose sidewalls of the vertical portions of the first and second dummy vertical structures DP1 and DP2, and the second gate regions G2 may expose sidewalls of the extensions of the first and second dummy vertical structures DP1 and DP2. In the second direction D2, the extensions of the first dummy vertical structures DP1 may be disposed between the second gate regions G2.

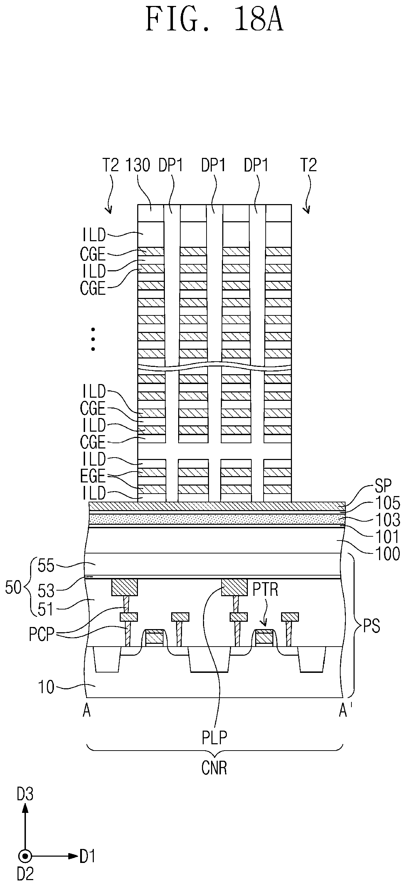

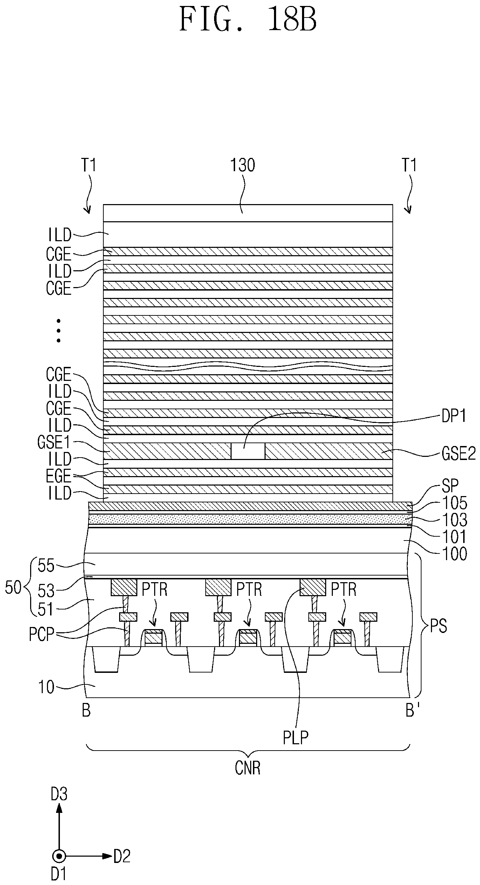

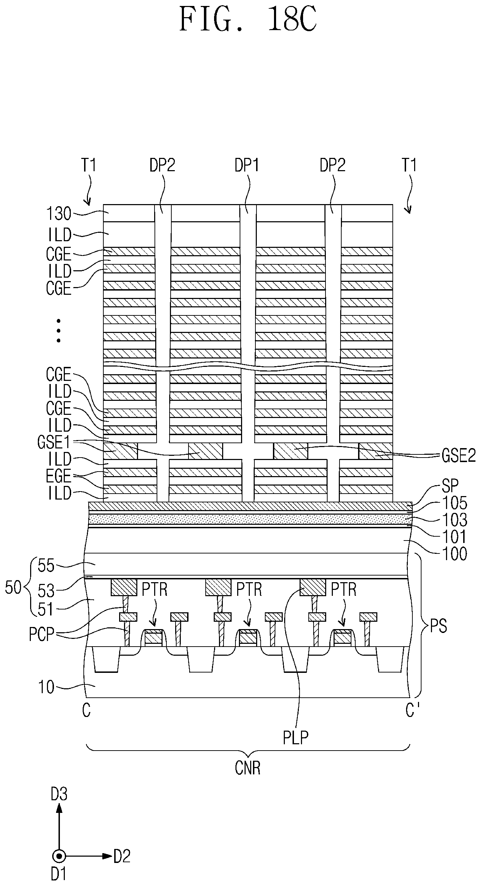

Referring to FIGS. 5, 18A, 18B, and 18C, gate patterns EGE, GSE1, GSE2, and CGE may be formed in the first and second gate regions G1 and G2.

The forming of the gate patterns EGE, GSE1, GSE2, and CGE may include filling the first and second gate regions G1 and G2, depositing a metal layer to conformally cover inner walls of the first and second isolation trenches T1 and T2, and isotropically etching the metal layer to expose sidewalls of the interlayer insulating layers ILD in the first and second isolation trenches T1 and T2. Accordingly, the erase control gate patterns EGE and cell gate patterns CGE may be formed in the first gate regions G1, and first and second ground selection gate patterns GSE1 and GSE2 may be formed in the second gate regions G2.

Meanwhile, before the forming of the gate patterns EGE, GSE1, GSE2, and CGE, a process of replacing the first, second, and third insulating layers 101, 103, and 105 with a source conductive pattern SC may be performed in the cell array region CAR.

After the forming of the gate patterns EGE, GSE1, GSE2, and CGE, referring to FIGS. 6A to 6D, an insulating material is buried in the first and second isolation trenches T1 and T2 to form first and second separation structures SS1 and SS2 may be formed. Afterwards, bit lines BL and through contact plugs TPLG may be formed.

According to some example embodiments of the present disclosure, in the stacked structure including the alternately stacked gate patterns and interlayer insulating layers, the ground selection gate patterns may be separated from each other through the dummy vertical structure and the separation structures without the patterns to horizontally separate the ground selection gate patterns.

The interlayer insulating layers in the stacked structure may be deposited to substantially the same thickness, thereby simplifying the manufacturing process of the semiconductor device.

Embodiments are set out in the following clauses:
Clause 1. A semiconductor device comprising: a substrate including a cell array region and a connection region; a plurality of ground selection gate patterns with each ground selection gate pattern spaced apart from each other and disposed at the same level as each other relative to a top surface of the substrate; a plurality of cell gate patterns vertically stacked on the plurality of ground selection gate patterns; a plurality of separation structures, with each separation structure vertically extending into the cell gate patterns and disposed between respective ground selection gate patterns of the plurality of ground selection gate patterns and spaced apart from each other in a first direction in the connection region; and a plurality of dummy vertical structures disposed between a first separation structure and a second separation structure that are adjacent in the first direction and between a first ground selection gate pattern and a second ground selection gate pattern adjacent to the first ground selection gate pattern, wherein each of the dummy vertical structures includes: a vertical portion that extends vertically into the cell gate patterns; and an extension that protrudes horizontally from the vertical portion at the same level as the ground selection gate patterns, and wherein the extension of each of the dummy vertical structures are connected to each other and are in contact with the first separation structure and the second separation structure.
Clause 2. The semiconductor device of clause 1, wherein each of the cell gate patterns has a first thickness in a vertical direction, and each of the ground selection gate patterns has a second thickness in the vertical direction greater than the first thickness.
Clause 3. The semiconductor device of clause 1, wherein each of the cell gate patterns has a first thickness in a vertical direction, and each of the ground selection gate patterns has a second thickness in the vertical direction that is equal to the first thickness.
Clause 4. The semiconductor device of any preceding clause, wherein a thickness in a vertical direction of the extension of each of the dummy vertical structures is the same as a thickness in the vertical direction of the ground selection gate patterns.
Clause 5. The semiconductor device of any preceding clause, wherein a distance between a first cell gate pattern and a second cell gate pattern that is vertically adjacent to the first cell gate pattern is equal to a distance between the first cell gate pattern and a ground selection gate pattern that is vertically adjacent to the first cell gate pattern.
Clause 6. The semiconductor device of any preceding clause, wherein a distance between the first separation structure and the second separation structure in the first direction is greater than the sum of the diameters of the vertical portions of the dummy vertical structures.
Clause 7. The semiconductor device of any preceding clause, wherein the cell gate patterns surround the vertical portions of the dummy vertical structures in the connection region.
Clause 8. The semiconductor device of any preceding clause, wherein the cell gate patterns overlap the extension of each of the dummy vertical structures.
Clause 9. The semiconductor device of any preceding clause, wherein sidewalls of the ground selection gate patterns are in contact with the separation structures and the extension of each of the dummy vertical structures.
Clause 10. The semiconductor device of any preceding clause, wherein the dummy vertical structures are formed of an insulating material.
Clause 11. The semiconductor device of any preceding clause, wherein each of the dummy vertical structures further includes cell extensions with each cell extension horizontally protruding from the vertical portion at the same level as a respective cell gate pattern, and wherein diameters of the cell extensions are smaller than diameters of the extension of each of the dummy vertical structures.
Clause 12. A semiconductor device comprising: a substrate including a cell array region and a connection region; first separation structures extending in a first direction parallel to a top surface of the substrate; a stacked structure disposed between first separation structures that are adjacent in a second direction perpendicular to the first direction and including gate patterns and interlayer insulating layers alternately stacked vertically on the substrate, the gate patterns including a plurality of ground selection gate patterns with each ground selection gate pattern spaced apart from each other at the same level from the top surface of the substrate, and a plurality of cell gate patterns vertically stacked on the plurality of ground selection gate patterns; second separation structures extending into the plurality of cell gate patterns and disposed between the ground selection gate patterns that are adjacent in the second direction, and spaced apart from each other in the connection region in the first direction; first dummy vertical structures disposed between second separation structures adjacent to each other in the first direction and between the ground selection gate patterns that are adjacent in the second direction; and second dummy vertical structures extending into the stacked structure in the connection region, wherein each of the first and second dummy vertical structures includes a vertical portion that extends vertically into the cell gate patterns and an extension that protrudes horizontally from the vertical portion at the same level as the ground selection gate patterns, and wherein each extension of the first dummy vertical structures are connected to each other and are in contact with the second separation structures that are adjacent to each other in the first direction.
Clause 13. The semiconductor device of clause 12, wherein each of the cell gate patterns has a first thickness in a vertical direction, and each of the ground selection gate patterns has a second thickness in the vertical direction that is greater than the first thickness.
Clause 14. The semiconductor device of clause 12 or 13, wherein a thickness in a vertical direction of each extension of the first dummy vertical structures is substantially the same as a thickness in the vertical direction of the ground selection gate patterns.
Clause 15. The semiconductor device of clause 12, 13 or 14, wherein the cell gate patterns surround the vertical portions of the first and second dummy vertical structures.
Clause 16. The semiconductor device of clause 12, 13, 14 or 15, wherein the ground selection gate patterns surround each extension of the second dummy vertical structures.
Clause 17. The semiconductor device of any one of clauses 12 to 16, wherein diameters of the vertical portions of the first dummy vertical structures are equal to diameters of the vertical portions of the second dummy vertical structures.
Clause 18. The semiconductor device of any one of clauses 12 to 17, wherein the first and second dummy vertical structures are formed of an insulating material.
Clause 19. The semiconductor device of any one of clauses 12 to 18, further comprising through contact plugs connected to pad portions of the cell gate patterns in the connection region, wherein each of the second dummy vertical structures is disposed around a respective through contact plug.
Clause 20. An electronical system comprising: a semiconductor device including a substrate including a cell array region and a connection region, a plurality of ground selection gate patterns with each ground selection gate pattern spaced apart from each other and disposed at the same level from a top surface of the substrate, a plurality of cell gate patterns vertically stacked on the plurality of ground selection gate patterns, separation structures vertically extending into the cell gate patterns and disposed between adjacent ground selection gate patterns of the plurality of ground selection gate patterns, and spaced apart from each other in the connection region in a first direction, and dummy vertical structures between adjacent separation structures and between the adjacent ground selection gate patterns, and an input/output pad electrically connected to peripheral circuits; and a controller electrically connected to the semiconductor device through the input/output pad and controlling the semiconductor device, wherein each of the dummy vertical structures includes: a vertical portion that vertically extends into the cell gate patterns; and an extension that protrudes horizontally from the vertical portion at the same level as the ground selection gate patterns, and wherein the extension of each of the dummy vertical structures are connected to each other and are in contact with the separation structures adjacent to each other in the first direction.

While embodiments are described above, a person skilled in the art may understand that many modifications and variations are made without departing from the scope of the inventive concept defined in the following claims. Accordingly, the example embodiments of the inventive concept should be considered in all respects as illustrative and not restrictive, with the scope of the inventive concept being indicated by the appended claims.

## Claims

1. A semiconductor device comprising:
a substrate including a cell array region and a connection region;
a plurality of ground selection gate patterns with each ground selection gate pattern spaced apart from each other and disposed at the same level as each other relative to a top surface of the substrate;
a plurality of cell gate patterns vertically stacked on the plurality of ground selection gate patterns;
a plurality of separation structures, with each separation structure vertically extending into the cell gate patterns and disposed between respective ground selection gate patterns of the plurality of ground selection gate patterns and spaced apart from each other in a first direction in the connection region; and
a plurality of first dummy vertical structures disposed between a first separation structure and a second separation structure that are adjacent in the first direction and between a first ground selection gate pattern and a second ground selection gate pattern adjacent to the first ground selection gate pattern,
wherein each of the first dummy vertical structures includes:
a vertical portion that extends vertically into the cell gate patterns; and
an extension that protrudes horizontally from the vertical portion at the same level as the ground selection gate patterns, and
wherein the extension of each of the first dummy vertical structures are connected to each other and are in contact with the first separation structure and the second separation structure.

2. The semiconductor device of claim 1, wherein each of the cell gate patterns has a first thickness in a vertical direction, and each of the ground selection gate patterns has a second thickness in the vertical direction greater than the first thickness.

3. The semiconductor device of claim 1, wherein each of the cell gate patterns has a first thickness in a vertical direction, and each of the ground selection gate patterns has a second thickness in the vertical direction that is equal to the first thickness.

4. The semiconductor device of any preceding claim, wherein a thickness in a vertical direction of the extension of each of the first dummy vertical structures is the same as a thickness in the vertical direction of the ground selection gate patterns.

5. The semiconductor device of any preceding claim, wherein a distance between a first cell gate pattern and a second cell gate pattern that is vertically adjacent to the first cell gate pattern is equal to a distance between the first cell gate pattern and a ground selection gate pattern that is vertically adjacent to the first cell gate pattern.

6. The semiconductor device of any preceding claim, wherein a distance between the first separation structure and the second separation structure in the first direction is greater than the sum of the diameters of the vertical portions of the first dummy vertical structures.

7. The semiconductor device of any preceding claim, wherein the cell gate patterns surround the vertical portions of the first dummy vertical structures in the connection region.

8. The semiconductor device of any preceding claim, wherein the cell gate patterns overlap the extension of each of the first dummy vertical structures.

9. The semiconductor device of any preceding claim, wherein sidewalls of the ground selection gate patterns are in contact with the separation structures and the extension of each of the first dummy vertical structures.

10. The semiconductor device of any preceding claim, wherein the first dummy vertical structures are formed of an insulating material.

11. The semiconductor device of any preceding claim, wherein each of the first dummy vertical structures further includes cell extensions with each cell extension horizontally protruding from the vertical portion at the same level as a respective cell gate pattern, and
wherein diameters of the cell extensions are smaller than diameters of the extension of each of the first dummy vertical structures.

12. The semiconductor device of any preceding claim, further comprising second dummy vertical structures extending into the stacked structure in the connection region,
wherein each of the second dummy vertical structures includes:
a vertical portion that extends vertically into the cell gate patterns; and
an extension that protrudes horizontally from the vertical portion at the same level as the ground selection gate patterns.

13. The semiconductor device of claim 12, wherein the ground selection gate patterns surround each extension of the second dummy vertical structures.

14. The semiconductor device of claim 12 or 13, wherein diameters of the vertical portions of the first dummy vertical structures are equal to diameters of the vertical portions of the second dummy vertical structures.

15. The semiconductor device of any one of claims 12, 13 and 14, further comprising through contact plugs connected to pad portions of the cell gate patterns in the connection region,
wherein each of the second dummy vertical structures is disposed around a respective through contact plug.
